# EUROPEAN PATENT APPLICATION

(11) **EP 4 794 205 A1**
(43) Date of publication of application: **19.08.2026**
(21) Application number: 24884573.7
(22) Date of filing: 24.10.2024
(51) Int. Cl.: H03M 13/11

(54) **COMMUNICATION METHOD BASED ON LDPC CODE, AND COMMUNICATION APPARATUS**

(30) Priority: 30.10.2023 CN 202311433976
(71) Applicant: HUAWEI TECHNOLOGIES CO., LTD., Shenzhen 518129 (CN)
(72) Inventor: LIU, Ke, Shenzhen, Guangdong 518129 (CN); ZHANG, Huazi, Shenzhen, Guangdong 518129 (CN); TONG, Jiajie, Shenzhen, Guangdong 518129 (CN); WANG, Xianbin, Shenzhen, Guangdong 518129 (CN); QIN, Kangjian, Shenzhen, Guangdong 518129 (CN); WANG, Jun, Shenzhen, Guangdong 518129 (CN)
(74) Representative: Grünecker Patent- und Rechtsanwälte PartG mbB
(86) International application number: PCT/CN2024/127126
(87) International publication number: WO 2025/092569

(57) **Abstract**

Disclosed are an LDPC code-based communication method and a communication apparatus. Encoding or decoding may be performed based on a storage matrix and indication information. The indication information may include first information. Each row pair in a plurality of row pairs indicated by the first information includes two rows. A set of column numbers of columns in which non-zero elements in first x elements of a first row in the two rows are located is a proper subset of a set of column numbers of columns in which non-zero elements in first x elements of a second row in the two rows are located. In this way, split extension is implemented in a low-code-rate extension process, that is, elimination can be performed on the first row on a basis of adding the second row, to improve orthogonality between rows. In addition, a plurality of first rows indicated by the first information may form one or more row groups, and the first rows included in each row group have an association relationship. Based on the association relationship, the orthogonality can be further improved. Therefore, the orthogonality between the rows is enhanced, which helps improve decoding performance.

## Description

This application claims priority to Chinese Patent Application No. 202311433976.3, filed with the China National Intellectual Property Administration on October 30, 2023 and entitled "LDPC CODE-BASED COMMUNICATION METHOD AND COMMUNICATION APPARATUS", which is incorporated herein by reference in its entirety.

### TECHNICAL FIELD

This application relates to the coding field, and more specifically, to an LDPC code-based communication method and a communication apparatus.

### BACKGROUND

In the field of channel coding, low-density parity-check (low-density parity check, LDPC) codes are among the most mature and widely applied channel coding schemes. In existing LDPC codes, there is low orthogonality between rows of an LDPC base matrix, which affects decoding efficiency and performance. For example, in a high-code-rate part of a new radio (new radio, NR) LDPC code, edge density is high, and rows generally lack orthogonality. As a result, only parallel decoding of quasi-cyclic (quasi-cyclic, QC) blocks is supported.

### SUMMARY

Embodiments of this application provide an LDPC code-based communication method and a communication apparatus, to help improve decoding performance.

According to a first aspect, an LDPC code-based communication method is provided. The method may be performed by a transmit-end device, or a module or unit (for example, a chip) in the transmit-end device. The transmit-end device may be a terminal device or a network device.

The method includes: obtaining an information bit sequence; performing LDPC encoding on the information bit sequence based on a first LDPC base matrix and indication information to obtain an LDPC codeword sequence; and sending the LDPC codeword sequence. The indication information includes first information. The first information indicates a plurality of row pairs. Each row pair in the plurality of row pairs includes a first row and a second row. A set of column numbers of columns in which non-zero elements in first x elements of the first row in the row pair are located is a proper subset of a set of column numbers of columns in which non-zero elements in first x elements of the second row in the row pair are located. x is a positive integer. The plurality of first rows indicated by the first information form one or more row groups. Each row group in the one or more row groups includes at least two of the first rows. A column weight of each column in a matrix region formed by the second rows corresponding to the at least two first rows is less than or equal to 2. The at least two first rows have an association relationship.

For example, x is a total quantity of information columns and core check columns.

In the foregoing method, each row pair in the plurality of row pairs indicated by the first information includes two rows. The set of the column numbers of the columns in which the non-zero elements in the first x elements of the first row in the two rows are located is the proper subset of the set of the column numbers of the columns in which the non-zero elements in the first x elements of the second row in the two rows are located. In this way, split extension can be implemented in a low-code-rate extension process, that is, elimination can be performed on the first row on a basis of adding the second row, to improve orthogonality between rows. In addition, the plurality of first rows indicated by the first information may form the one or more row groups, and the at least two first rows included in each row group have an association relationship, so that the orthogonality can be further improved based on the association relationship. For example, rows that are of a second LDPC base matrix and that correspond to first rows in a row group and rows that are of the second LDPC base matrix and that correspond to second rows corresponding to the first rows in the row group can be regrouped based on the association relationship, so that rows in each newly obtained group are completely orthogonal to each other. Therefore, based on the foregoing method, the orthogonality between the rows can be improved. This helps implement row-parallel decoding of a receive-end device, to improve decoding performance.

With reference to the first aspect, in some implementations, performing LDPC encoding on the information bit sequence based on the first LDPC base matrix and the indication information to obtain the LDPC codeword sequence includes: obtaining a second LDPC base matrix based on the first LDPC base matrix and the indication information; and performing LDPC encoding on the information bit sequence based on the second LDPC base matrix to obtain the LDPC codeword sequence. A row that is of the second LDPC base matrix and that corresponds to the first row is obtained by performing elimination on the second row in the same row pair as the first row.

In the foregoing implementations, when the second LDPC base matrix used for encoding is obtained, the row that is of the second LDPC base matrix and that corresponds to the first row is obtained by performing elimination on the second row in the same row pair as the first row. In this way, the orthogonality between the rows can be improved. This helps implement row-parallel decoding of the receive-end device, to improve the decoding performance.

With reference to any one of the first aspect or the implementations of the first aspect, in some other implementations, the association relationship includes a first association relationship and/or a second association relationship. The two first rows having the first association relationship are orthogonal to each other, and a union set of column numbers of columns in which non-zero elements of the two first rows are located includes an intersection set of column numbers of columns in which non-zero elements of the two second rows corresponding to the two first rows are located. The two first rows having the second association relationship have a same connection edge at a first position, and a column number of the first position belongs to an intersection set of column numbers of columns in which non-zero elements of the two second rows corresponding to the two first rows are located.

In the foregoing implementations, possible implementations of an association relationship between at least two first rows included in a row group are provided. Based on these possible implementations, rows that are of the second LDPC base matrix and that correspond to first rows in a row group and rows that are of the second LDPC base matrix and that correspond to second rows corresponding to the first rows in the row group can be regrouped, so that rows in each newly obtained group are completely orthogonal to each other.

For example, rows that are of the second LDPC base matrix and that correspond to first rows in a row group and rows that are of the second LDPC base matrix and that correspond to second rows corresponding to the first rows in the row group may be divided into two groups, which are referred to as a first row set and a second row set. A union set of the first row set and the second row set includes rows that are of the second LDPC base matrix and that correspond to first rows in a row group and rows that are of the second LDPC base matrix and that correspond to second rows corresponding to the first rows in the row group.

The first row set consists of rows that are of the second LDPC base matrix and that correspond to rows in a first subset and/or rows that are of the second LDPC base matrix and that correspond to rows in a second subset. The rows in the first subset are all the first rows. Every two of the first rows in the first subset have the first association relationship. The rows in the second subset are all the second rows. The first rows corresponding to the second rows in the second subset have the second association relationship with the first rows in the first subset.

The second row set consists of rows that are of the second LDPC base matrix and that correspond to rows in a third subset and/or rows that are of the second LDPC base matrix and that correspond to rows in a fourth subset. The third subset consists of the second rows corresponding to the first rows in the first subset. The fourth subset consists of the first rows corresponding to the second rows in the second subset. Every two of the first rows in the fourth subset have the first association relationship.

It should be noted that when there is only one row in the first row set, the first subset, the second subset, the second row set, the third subset, or the fourth subset, definitions of these sets may not involve descriptions of the first association relationship and/or the second association relationship.

With reference to any one of the first aspect or the implementations of the first aspect, in some other implementations, in pairwise combinations of the at least two first rows, a quantity of combinations having the first association relationship and a quantity of combinations having the second association relationship are related to a quantity of the first rows included in the at least two first rows.

With reference to any one of the first aspect or the implementations of the first aspect, in some other implementations, in the pairwise combinations of the at least two first rows, $\left(\begin{matrix}k - i \\ 2\end{matrix}\right) + \left(\begin{matrix}i \\ 2\end{matrix}\right)$ combinations have the first association relationship, and $\left(\begin{matrix}k \\ 2\end{matrix}\right) - \left(\begin{matrix}k - i \\ 2\end{matrix}\right) - \left(\begin{matrix}i \\ 2\end{matrix}\right)$ combinations have the second association relationship. *k* is the quantity of the first rows included in the at least two first rows. $0 \leq i \leq \left⌊\frac{k}{2}\right⌋$. $\left(\begin{matrix}k - i \\ 2\end{matrix}\right)$ represents a quantity of combinations of any two rows selected from *k* - *i* rows. $\left(\begin{matrix}k \\ 2\end{matrix}\right)$ represents a quantity of combinations of any two rows selected from *k* rows. (2) represents a quantity of combinations of any two rows selected from *i* rows. └ ┘ represents rounding down.

Based on a quantity relationship between the combinations having the first association relationship and the combinations having the second association relationship provided in the foregoing embodiments, rows that are of the second LDPC base matrix and that correspond to first rows in a row group and rows that are of the second LDPC base matrix and that correspond to second rows corresponding to the first rows in the row group can be regrouped, so that rows in each newly obtained group are completely orthogonal to each other.

With reference to any one of the first aspect or the implementations of the first aspect, in some other implementations, for a row group including k first rows, there are a total of $\left⌈\frac{k - 1}{2}\right⌉ +$ 1 allocation manners of a quantity of combinations having the first association relationship and a quantity of combinations having the second association relationship. In pairwise combinations of the first rows in the row group, $\left(\begin{matrix}k - i \\ 2\end{matrix}\right) + \left(\begin{matrix}i \\ 2\end{matrix}\right)$ combinations have the first association relationship, and $\left(\begin{matrix}k \\ 2\end{matrix}\right) - \left(\begin{matrix}k - i \\ 2\end{matrix}\right) - \left(\begin{matrix}i \\ 2\end{matrix}\right)$ combinations have the second association relationship. $0 \leq i \leq \left⌈\frac{k - 1}{2}\right⌉$. $\left(\begin{matrix}k - i \\ 2\end{matrix}\right)$ represents a quantity of combinations of any two rows selected from *k - i* rows. $\left(\begin{matrix}k \\ 2\end{matrix}\right)$ represents a quantity of combinations of any two rows selected from *k* rows. $\left(\begin{matrix}i \\ 2\end{matrix}\right)$ represents a quantity of combinations of any two rows selected from *i* rows. ┌ ┐ represents rounding up.

Based on a quantity relationship between the combinations having the first association relationship and the combinations having the second association relationship provided in the foregoing embodiments, rows that are of the second LDPC base matrix and that correspond to first rows in a row group and rows that are of the second LDPC base matrix and that correspond to second rows corresponding to the first rows in the row group can be regrouped, so that rows in each newly obtained group are completely orthogonal to each other.

With reference to any one of the first aspect or the implementations of the first aspect, in some other implementations, each row pair in the plurality of row pairs corresponds to two rows in the first LDPC base matrix. The indication information is in a form of a sequence. The first information is a sequence consisting of a row number of the second row in each of the one or more row pairs. In one of the row pairs, a position of the row number of the second row in the sequence corresponding to the indication information is a row number of the first row. The position of the row number of the second row in the sequence corresponding to the indication information is greater than the row number of the first row.

With reference to any one of the first aspect or the implementations of the first aspect, in some other implementations, the sequence corresponding to the first information includes one or more segments. Row numbers in a *t^{th}* segment of the one or more segments are a permutation form of {1, 2,..., 2^{*t*-1} M - 1, 2^{*t*-1}M}. *t* and M are positive integers.

For example, M may be a quantity of core rows.

In the foregoing implementations, each row number appears only once in one round of splitting. Therefore, a plurality of splits included in each round can be performed in parallel, to help improve splitting efficiency.

With reference to any one of the first aspect or the implementations of the first aspect, in some other implementations, the indication information further includes second information. The second information indicates one or more third rows. The one or more third rows of the second LDPC base matrix are the same as the one or more third rows of the first LDPC base matrix.

The second information may correspond to conventional extension, also referred to as normal extension.

In the foregoing implementations, the indication information includes two types of information. One type of information indicates one or more row pairs and corresponds to split extension. The other type of information indicates one or more rows and corresponds to conventional extension. Therefore, the indication information can indicate two different low-code-rate extension manners through the two types of information. In other words, in a low-code-rate extension process, there are two extension manners, and which of the two manners is used for an extension can be determined through the indication information. In this way, in comparison with using only one extension manner, low-code-rate extension in the foregoing method is more flexible, to help obtain an LDPC base matrix with better performance.

With reference to any one of the first aspect or the implementations of the first aspect, in some other implementations, the second information includes one or more first characters. Positions of the one or more first characters in the sequence corresponding to the indication information correspond to row numbers of the one or more third rows.

With reference to any one of the first aspect or the implementations of the first aspect, in some other implementations, the indication information further includes third information. The third information indicates one or more fourth rows. The one or more fourth rows of the second LDPC base matrix are the same as the one or more fourth rows of the first LDPC base matrix. Rows indicated by fourth information may be core rows of the second LDPC base matrix.

With reference to any one of the first aspect or the implementations of the first aspect, in some other implementations, the third information includes M second characters or M row numbers. The M row numbers are sequentially 1, 2, ..., M - 1, and M. M is a positive integer.

For example, M may be a quantity of core rows.

With reference to any one of the first aspect or the implementations of the first aspect, in some other implementations, the first character and/or the second character are/is a value other than a row number of the first LDPC base matrix.

The first character or the second character is set to the value other than the row number of the first LDPC base matrix, so that the first character or the second character can be well distinguished from the row number in the first information.

With reference to any one of the first aspect or the implementations of the first aspect, in some other implementations, the sequence corresponding to the indication information sequentially includes a first segment, a second segment, a third segment, a fourth segment, and a fifth segment. The first segment consists of the third information. The second segment consists of a first part of the second information. The third segment consists of a first part of the first information. The fourth segment consists of a second part of the first information and a second part of the second information. The fifth segment consists of a third part of the second information.

Based on the foregoing sequence, it is helpful to ensure that an optimal edge density is maintained during each extension.

With reference to any one of the first aspect or the implementations of the first aspect, in some other implementations, the third segment includes one or more sub-segments. Row numbers in an *r^{th}* segment of the one or more sub-segments are a permutation form of {1, 2, ..., 2^{*r*-1}(M + T) - 1, 2^{*r*-1}(M + T)}. *r* is a positive integer. T is a quantity of characters in the first part of the second information.

For example, M may be a quantity of core rows.

In the foregoing implementations, each row number appears only once in one round of splitting. Therefore, a plurality of splits included in each round can be performed in parallel, to help improve splitting efficiency.

According to a second aspect, an LDPC code-based communication method is provided. The method may be performed by a receive-end device, or a module or unit (for example, a chip) in the receive-end device. The receive-end device may be a terminal device or a network device. For terms or features in the second aspect or the implementations of the second aspect that are the same as or correspond to those in the first aspect or the implementations of the first aspect, refer to the first aspect or the implementations of the first aspect. For technical effects thereof, refer to technical effects of the first aspect or the implementations of the first aspect. Details are not described in the second aspect again.

The method includes: receiving an LDPC codeword sequence; and decoding the LDPC codeword sequence based on a first LDPC base matrix and indication information. The indication information includes first information. The first information indicates a plurality of row pairs. Each row pair in the plurality of row pairs includes a first row and a second row. A set of column numbers of columns in which non-zero elements in first x elements of the first row in the row pair are located is a proper subset of a set of column numbers of columns in which non-zero elements in first x elements of the second row in the row pair are located. x is a positive integer. The plurality of first rows indicated by the first information form one or more row groups. Each row group in the one or more row groups includes at least two of the first rows. A column weight of each column in a matrix region formed by the second rows corresponding to the at least two first rows is less than or equal to 2. The at least two first rows have an association relationship.

With reference to the second aspect, in some implementations, decoding the LDPC codeword sequence based on the first LDPC base matrix and the indication information includes: obtaining a second LDPC base matrix based on the first LDPC base matrix and the indication information; and decoding the LDPC codeword sequence based on the second LDPC base matrix. A row that is of the second LDPC base matrix and that corresponds to the first row is obtained by performing elimination on the second row in the same row pair as the first row.

With reference to any one of the second aspect or the implementations of the second aspect, in some other implementations, the association relationship includes a first association relationship and/or a second association relationship. The two first rows having the first association relationship are orthogonal to each other, and a union set of column numbers of columns in which non-zero elements of the two first rows are located includes an intersection set of column numbers of columns in which non-zero elements of the two second rows corresponding to the two first rows are located. The two first rows having the second association relationship have a same connection edge at a first position, and a column number of the first position belongs to an intersection set of column numbers of columns in which non-zero elements of the two second rows corresponding to the two first rows are located.

With reference to any one of the second aspect or the implementations of the second aspect, in some other implementations, decoding the LDPC codeword sequence based on the second LDPC base matrix includes: performing row-parallel decoding on a part that is of the LDPC codeword sequence and that corresponds to rows in a first row set, and performing row-parallel decoding on a part that is of the LDPC codeword sequence and that corresponds to rows in a second row set. A union set of the first row set and the second row set includes rows that are of the second LDPC base matrix and that correspond to the at least two first rows and rows that are of the second LDPC base matrix and that correspond to the second rows corresponding to the at least two first rows. The first row set consists of rows that are of the second LDPC base matrix and that correspond to rows in a first subset and/or rows that are of the second LDPC base matrix and that correspond to rows in a second subset. The rows in the first subset are all the first rows. Every two of the first rows in the first subset have the first association relationship. The rows in the second subset are all the second rows. The first rows corresponding to the second rows in the second subset have the second association relationship with the first rows in the first subset. The second row set consists of rows that are of the second LDPC base matrix and that correspond to rows in a third subset and/or rows that are of the second LDPC base matrix and that correspond to rows in a fourth subset. The third subset consists of the second rows corresponding to the first rows in the first subset. The fourth subset consists of the first rows corresponding to the second rows in the second subset. Every two of the first rows in the fourth subset have the first association relationship.

With reference to any one of the second aspect or the implementations of the second aspect, in some other implementations, in pairwise combinations of the at least two first rows, a quantity of combinations having the first association relationship and a quantity of combinations having the second association relationship are related to a quantity of the first rows included in the at least two first rows.

With reference to any one of the second aspect or the implementations of the second aspect, in some other implementations, in the pairwise combinations of the at least two first rows, $\left(\begin{matrix}k - i \\ 2\end{matrix}\right) + \left(\begin{matrix}i \\ 2\end{matrix}\right)$ combinations have the first association relationship, and $\left(\begin{matrix}k \\ 2\end{matrix}\right) - \left(\begin{matrix}k - i \\ 2\end{matrix}\right) - \left(\begin{matrix}i \\ 2\end{matrix}\right)$ combinations have the second association relationship. *k* is the quantity of the first rows included in the at least two first rows. $0 \leq i \leq \left⌊\frac{k}{2}\right⌋$. $\left(\begin{matrix}k - i \\ 2\end{matrix}\right)$ represents a quantity of combinations of any two rows selected from *k - i* rows. $\left(\begin{matrix}k \\ 2\end{matrix}\right)$ represents a quantity of combinations of any two rows selected from *k* rows. $\left(\begin{matrix}i \\ 2\end{matrix}\right)$ represents a quantity of combinations of any two rows selected from *i* rows. └ ┘ represents rounding down.

With reference to any one of the second aspect or the implementations of the second aspect, in some other implementations, for a row group including k first rows, there are a total of $\left⌈\frac{k - 1}{2}\right⌉ + 1$ allocation manners of a quantity of combinations having the first association relationship and a quantity of combinations having the second association relationship. In pairwise combinations of the first rows in the row group, $\left(\begin{matrix}k - i \\ 2\end{matrix}\right) + \left(\begin{matrix}i \\ 2\end{matrix}\right)$ combinations have the first association relationship, and $\left(\begin{matrix}k \\ 2\end{matrix}\right) - \left(\begin{matrix}k - i \\ 2\end{matrix}\right) - \left(\begin{matrix}i \\ 2\end{matrix}\right)$ combinations have the second association relationship. $0 \leq i \leq \left⌈\frac{k - 1}{2}\right⌉$. $\left(\begin{matrix}k - i \\ 2\end{matrix}\right)$ represents a quantity of combinations of any two rows selected from *k* - *i* rows. $\left(\begin{matrix}k \\ 2\end{matrix}\right)$ represents a quantity of combinations of any two rows selected from *k* rows. (2) represents a quantity of combinations of any two rows selected from *i* rows. ┌ ┐ represents rounding up.

With reference to any one of the second aspect or the implementations of the second aspect, in some other implementations, each row pair in the plurality of row pairs corresponds to two rows in the first LDPC base matrix. The indication information is in a form of a sequence. The first information is a sequence consisting of a row number of the second row in each of the one or more row pairs. In one of the row pairs, a position of the row number of the second row in the sequence corresponding to the indication information is a row number of the first row. The position of the row number of the second row in the sequence corresponding to the indication information is greater than the row number of the first row.

With reference to any one of the second aspect or the implementations of the second aspect, in some other implementations, the sequence corresponding to the first information includes one or more segments. Row numbers in a *t^{th}* segment of the one or more segments are a permutation form of {1, 2,..., 2^{*t*-1} M - 1, 2^{*t*-1}M}. *t* and M are positive integers.

With reference to any one of the second aspect or the implementations of the second aspect, in some other implementations, the indication information further includes second information. The second information indicates one or more third rows.

With reference to any one of the second aspect or the implementations of the second aspect, in some other implementations, the second information includes one or more first characters. Positions of the one or more first characters in the sequence corresponding to the indication information correspond to row numbers of the one or more third rows.

With reference to any one of the second aspect or the implementations of the second aspect, in some other implementations, the indication information further includes third information. The third information indicates one or more fourth rows.

With reference to any one of the second aspect or the implementations of the second aspect, in some other implementations, the third information includes M second characters or M row numbers. The M row numbers are sequentially 1, 2, ..., M - 1, and M. M is a positive integer.

With reference to any one of the second aspect or the implementations of the second aspect, in some other implementations, the first character and/or the second character are/is a value other than a row number of the first LDPC base matrix.

With reference to any one of the second aspect or the implementations of the second aspect, in some other implementations, the sequence corresponding to the indication information sequentially includes a first segment, a second segment, a third segment, a fourth segment, and a fifth segment. The first segment consists of the third information. The second segment consists of a first part of the second information. The third segment consists of a first part of the first information. The fourth segment consists of a second part of the first information and a second part of the second information. The fifth segment consists of a third part of the second information.

With reference to any one of the second aspect or the implementations of the second aspect, in some other implementations, the third segment includes one or more sub-segments. Row numbers in an *r^{th}* segment of the one or more sub-segments are a permutation form of {1, 2, ..., 2^{*r*-1}(M + T) - 1, 2^{*r*-1}(M + T)}. *r* is a positive integer. T is a quantity of characters in the first part of the second information.

According to a third aspect, a communication apparatus is provided. The apparatus is configured to perform the method provided in any one of the foregoing aspects or the implementations of the foregoing aspects. Specifically, the apparatus may include a unit and/or a module configured to perform the method provided in any one of the foregoing aspects or the implementations of the foregoing aspects, for example, a processing unit and/or a transceiver unit.

In an implementation, the apparatus is a transmit-end device or a receive-end device. When the apparatus is the transmit-end device or the receive-end device, the transceiver unit may be a transceiver, an input/output interface, or a communication interface; and the processing unit may be at least one processor. Optionally, the transceiver is a transceiver circuit. Optionally, the input/output interface is an input/output circuit.

In another implementation, the apparatus is a chip, a chip system, or a circuit used in the transmit-end device or the receive-end device. When the apparatus is the chip, the chip system, or the circuit used in the transmit-end device or the receive-end device, the transceiver unit may be an input/output interface, an interface circuit, an output circuit, an input circuit, a pin, a related circuit, or the like on the chip, the chip system, or the circuit; and the processing unit may be at least one processor, a processing circuit, a logic circuit, or the like.

According to a fourth aspect, a communication apparatus is provided. The apparatus includes: a memory, configured to store a program; and at least one processor, configured to execute a computer program or instructions stored in the memory, to perform the method provided in any one of the foregoing aspects or the implementations of the foregoing aspects.

In an implementation, the apparatus is a transmit-end device or a receive-end device.

In another implementation, the apparatus is a chip, a chip system, or a circuit used in the transmit-end device or the receive-end device.

According to a fifth aspect, a communication apparatus is provided. The apparatus includes at least one processor and a communication interface. The at least one processor is configured to obtain, through the communication interface, a computer program or instructions stored in a memory, to perform the method provided in any one of the foregoing aspects or the implementations of the foregoing aspects. The communication interface may be implemented by hardware or software.

In an implementation, the apparatus further includes the memory.

According to a sixth aspect, a processor is provided, and is configured to perform the methods provided in the foregoing aspects.

Unless otherwise specified, or if operations such as sending and obtaining/receiving related to the processor do not conflict with actual functions or internal logic in related descriptions, the operations may be understood as operations such as output, receiving, and input of the processor, or may be understood as operations such as sending and receiving performed by a radio frequency circuit and an antenna. This is not limited in this application.

According to a seventh aspect, a computer-readable storage medium is provided. The computer-readable medium stores program code to be executed by a device. The program code is used to perform the method provided in any one of the foregoing aspects or the implementations of the foregoing aspects.

According to an eighth aspect, a computer program product including instructions is provided. When the computer program product runs on a computer, the computer is enabled to perform the method provided in any one of the foregoing aspects or the implementations of the foregoing aspects.

According to a ninth aspect, a chip is provided. The chip includes a processor and a communication interface. The processor reads, through the communication interface, instructions stored in a memory, to perform the method provided in any one of the foregoing aspects or the implementations of the foregoing aspects. The communication interface may be implemented by hardware or software.

Optionally, in an implementation, the chip further includes the memory. The memory stores a computer program or the instructions. The processor is configured to execute the computer program or the instructions stored in the memory. When the computer program or the instructions are executed, the processor is configured to perform the method provided in any one of the foregoing aspects or the implementations of the foregoing aspects.

When the method provided in this application is performed by the chip, a quantity of chips that specifically implement the method in this application is not limited in this application. For example, the method may be performed by one chip, or may be performed by two or more chips. In addition, when there are two or more chips that implement the method in this application, a chip vendor is not limited. The chips may be from a same vendor or from different vendors.

According to a tenth aspect, a communication system is provided, and includes at least one of the transmit-end device or the receive-end device described above.

According to an eleventh aspect, a computer program is provided. When the computer program is run on a computer, the method provided in any one of the foregoing aspects or the implementations of the foregoing aspects is performed.

### BRIEF DESCRIPTION OF DRAWINGS

FIG. 1 is a diagram of a network architecture to which embodiments of this application may be applied;
FIG. 2 is a diagram of an LDPC check matrix H;
FIG. 3 is a Tanner (Tanner) graph of an LDPC check matrix H;
FIG. 4A and FIG. 4B are diagrams of a structure of a check matrix;
FIG. 5 shows an example of a column-irregular group structure and a column-regular group structure;
FIG. 6A to FIG. 6C show an example of conventional extension and split extension;
FIG. 7 is a schematic flowchart of an LDPC code-based communication method 700 according to this application;
FIG. 8A to FIG. 8D are diagrams of a first association relationship;
FIG. 9A to FIG. 9D are diagrams of a second association relationship;
FIG. 10 shows an example of a technical solution according to an embodiment of this application;
FIG. 11 shows another example of a technical solution according to an embodiment of this application;
FIG. 12 shows another example of a technical solution according to an embodiment of this application;
FIG. 13 shows another example of a technical solution according to an embodiment of this application;
FIG. 14 shows a first simulation result of a signal-to-noise ratio (signal-noise ratio, SNR) difference between an NR LDPC code and an LDPC code in this application at different code rates;
FIG. 15 shows a second simulation result of an SNR difference between an NR LDPC code and an LDPC code in this application at different code rates;
FIG. 16 is a diagram of a structure of an apparatus according to an embodiment of this application;
FIG. 17 is a diagram of another structure of an apparatus according to an embodiment of this application; and
FIG. 18 is a diagram of a chip system according to an embodiment of this application.

### DESCRIPTION OF EMBODIMENTS

For ease of understanding of embodiments of this application, before embodiments of this application are described, the following several points are described first.

"Indicating" or "indicate" may include direct indicating and indirect indicating. In other words, "indicating" or "indicate" may be explicitly and/or implicitly indicating. Various numerical numbers such as first and second are merely used for differentiation for ease of description, and are not used to limit the scope of embodiments of this application, for example, to distinguish between different messages and different information. "Predefinition" may be implemented by pre-storing corresponding code or a corresponding table in a device, or may be implemented in another manner of indicating related information. A specific implementation of "predefinition" is not limited in this application. A related "protocol" may be a standard protocol in the communication field, for example, may include a long term evolution (long term evolution, LTE) protocol, an NR protocol, and a related protocol applied to a future communication system. This is not limited in this application. The terms such as "example", "for example", "for instance", and "in an (another) example" represent giving an example, an illustration, or a description. Any embodiment or design scheme described as an "example" in this application should not be explained as being more preferred or having more advantages than another embodiment or design scheme. The terms "include", "comprise", "have", and their variants all mean "include but are not limited to", unless otherwise specifically emphasized in another manner. "At least one" means one or more, and "a plurality of" means two or more. "At most one" means one or zero. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between associated objects. "At least one of the following items (pieces)" or a similar expression thereof indicates any combination of these items, including a single item (piece) or any combination of a plurality of items (pieces). For example, at least one of a, b, and c may indicate a, b, c, a and b, a and c, b and c, or a, b, and c. Each of a, b, and c may be in a singular form or a plural form. Related descriptions about sending a message, information, or data by a network element A to a network element B, and receiving the message, information, or data by the network element B from the network element A are intended to describe a network element to which the message, information, or data is to be sent. Whether the message, information, or data is directly sent or indirectly sent via another network element is not limited. Descriptions such as "when...", "in a case of...", and "if" all mean that a device performs corresponding processing in an objective case, and are not limited to time, and the device is not required to perform a determining action during implementation. This does not mean that there is another limitation.

In addition, a network architecture and a service scenario described in embodiments of this application are intended to describe the technical solutions in embodiments of this application more clearly, and do not constitute a limitation on the technical solutions provided in embodiments of this application. A person of ordinary skill in the art may know that: With evolution of the network architecture and emergence of a new service scenario, the technical solutions provided in embodiments of this application are also applicable to similar technical problems.

The following describes communication systems to which embodiments of this application may be applied.

Embodiments of this application may be applied to various communication systems, including but not limited to a 5th generation (5th generation, 5G) system, an NR system, an LTE system, a long term evolution-advanced (long term evolution-advanced, LTE-A) system, an LTE frequency division duplex (frequency division duplex, FDD) system, an LTE time division duplex (time division duplex, TDD) system, and the like. Embodiments of this application may be further applied to a future communication system, for example, a 6th generation mobile communication system. In addition, embodiments of this application may be further applied to device-to-device (device-to-device, D2D) communication, vehicle-to-everything (vehicle-to-everything, V2X) communication, machine-to-machine (machine-to-machine, M2M) communication, machine type communication (machine type communication, MTC), an internet of things (internet of things, IoT) communication system, a narrow band internet of things (narrow band internet of things, NB-IoT) system, or another communication system. In addition, embodiments of this application may be further extended to a similar wireless communication system, for example, a communication system related to wireless fidelity (wireless fidelity, Wi-Fi), worldwide interoperability for microwave access (worldwide interoperability for microwave access, WiMAX), and the 3rd generation partnership project (3rd generation partnership project, 3GPP). This is not limited.

The communication system applicable to embodiments of this application may include one or more transmit-end devices and one or more receive-end devices. Optionally, one of the transmit-end device and the receive-end device may be a terminal device, and the other may be a network device. Optionally, both the transmit-end device and the receive-end device may be terminal devices. Optionally, both the transmit-end device and the receive-end device may be network devices.

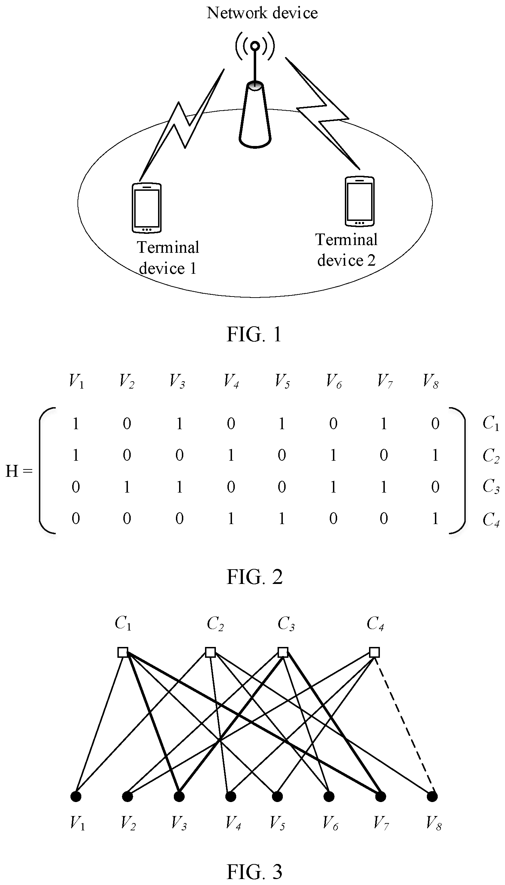

For example, FIG. 1 is a diagram of a network architecture to which embodiments of this application may be applied.

As shown in FIG. 1, embodiments of this application are applicable to both uplink data transmission and downlink data transmission. In FIG. 1, only uplink data transmission or downlink data transmission between one network device and two terminal devices (for example, a terminal device 1 and a terminal device 2) is used as an example. In the uplink data transmission, in this specification, a transmit-end device is the terminal device, and a receive-end device is the network device. On the contrary, in the downlink data transmission, a transmit-end device is the network device, and a receive-end device is the terminal device. In addition, applicability of embodiments of this application in another communication scenario is not limited. For example, embodiments of this application may also be applied to sidelink communication.

The terminal device in this application may also be referred to as user equipment (user equipment, UE), an access terminal, a subscriber unit, a subscriber station, a mobile station, a mobile platform, a mobile terminal (mobile terminal, MT), a remote station, a remote terminal, a mobile device, a user terminal, a terminal, an uncrewed aerial vehicle, a wireless communication device, a user agent, a user apparatus, or the like. The terminal device in embodiments of this application may be a device that provides voice and/or data connectivity for a user, and may be configured to connect a person, an object, and a machine, for example, a handheld device or a vehicle-mounted device having a wireless connection function. The terminal device in embodiments of this application may be a mobile phone (mobile phone), a tablet computer (pad), a notebook computer, a palmtop computer, a mobile internet device (mobile internet device, MID), a wearable device, a virtual reality (virtual reality, VR) device, an augmented reality (augmented reality, AR) device, a wireless terminal in industrial control (industrial control), a wireless terminal in self-driving (self-driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), or the like.

The network device in this application may be a device having a wireless transceiver function. The network device may be a device that provides a wireless communication function service, is usually located on a network side, and includes but is not limited to a next generation NodeB (gNodeB, gNB) in a 5G system, a base station in a 6th generation mobile communication system, a base station in a future mobile communication system, an access node in a wireless fidelity (wireless fidelity, Wi-Fi) system, an evolved NodeB (evolved NodeB, eNB) in a long term evolution (long term evolution, LTE) system, a radio network controller (radio network controller, RNC), a NodeB (NodeB, NB), a base station controller (base station controller, BSC), a home base station (for example, a home evolved NodeB, or a home NodeB, HNB), a baseband unit (baseband unit, BBU), a transmission reception point (transmission reception point, TRP), a transmission point (transmitting point, TP), a base transceiver station (base transceiver station, BTS), a satellite, an uncrewed aerial vehicle, and the like. In a network structure, the network device may include a central unit (central unit, CU) node or a distributed unit (distributed unit, DU) node; or may be a RAN device including a CU node and a DU node, or a RAN device including a CU-control plane node, a CU-user plane node, and a DU node. Alternatively, the network device may be a radio controller, a relay station, a vehicle-mounted device, a wearable device, and the like in a cloud radio access network (cloud radio access network, CRAN) scenario. In addition, the base station may be a macro base station, a micro base station, a relay node, a donor node, or a combination thereof. The base station may alternatively be a communication module, a modem, or a chip disposed in the foregoing device or apparatus. The base station may alternatively be a mobile switching center, a device that bears a base station function in D2D, V2X, and M2M communication, a network side device in a 6G network, a device that bears a base station function in a future communication system, or the like. The base station may support networks of a same access technology or different access technologies. This is not limited.

Unless otherwise specified, in this application, an apparatus configured to implement a function of the terminal device or the network device may be the terminal device or the network device, or may be an apparatus that can support the terminal device or the network device in implementing the function, for example, a chip system or a chip. Specifically, the apparatus is a system on a chip (system on a chip, SoC) or a modem (Modem). The apparatus may be installed in the terminal device or the network device. In embodiments of this application, the chip system may include a chip, or may include a chip and another discrete device.

It should be further noted that in some embodiments of this specification, a 5G system is used as an example to describe specific details of solutions. It may be understood that when the solutions are applied to another communication system, for example, an LTE system or a future communication system, messages, channels, information, or the like in the solutions may be replaced with messages, channels, information, or the like that can implement corresponding functions in the another communication system. This is not limited in this application.

In addition, embodiments of this application may be applied to various application scenarios, for example, a high-throughput scenario, a high-reliability scenario, a low-latency scenario, a high-reliability low-latency scenario, or a low-power scenario. The high-throughput scenario may be, for example, an enhanced mobile broadband (Enhanced Mobile Broadband, eMBB) scenario. The high-reliability low-latency scenario may be, for example, an URLLC (Ultra Reliable Low Latency Communication) scenario. The low-power scenario may be, for example, an M2M scenario, an MTC scenario, or an IoT scenario.

For ease of understanding of embodiments of this application, several concepts or terms in embodiments of this application are briefly described. The concepts or the terms described below are described based on concepts or terms specified in a protocol. However, this does not mean that embodiments of this application can be applied only to a current existing system, and the concepts or the terms in embodiments of this application can be applied to a future system. In addition, specific names of the concepts or the terms (for example, concepts or terms related to functional descriptions) may be adjusted with development of the future system.

### 1. LDPC code

The LDPC code is a linear block code, and a check matrix of the LDPC code is a sparse matrix. In an LDPC check matrix, a quantity of zero elements is far greater than a quantity of non-zero elements. In other words, a row weight and a column weight of the check matrix are much less than an LDPC code length. An LDPC code whose information bit sequence length is equal to q and whose code length is equal to n may be uniquely determined based on a check matrix of the LDPC code.

In 1981, Tanner (Tanner) represented LDPC codewords in a graph. This graph now is referred to as a Tanner graph. The Tanner graph and a check matrix are in a one-to-one correspondence. The Tanner graph includes two types of vertices. One type of vertex indicates codeword bits and is referred to as a variable node. The other type of vertex is a check node and indicates a check constraint relationship. Each check node indicates one check constraint relationship. The following provides descriptions with reference to FIG. 2 and FIG. 3.

FIG. 2 is a diagram of an LDPC check matrix H.

In FIG. 2, {Vᵢ} represents a variable node (variable node, VN) set, and {Cᵢ} represents a check node (check node, CN) set. In the check matrix H, each row indicates one check equation, each check equation corresponds to one check node, each column indicates one codeword bit, and each codeword bit corresponds to one variable node. In FIG. 2, there are eight variable nodes and four check nodes. If a codeword bit is included in a corresponding check equation, a related variable node and check node are connected by using a connection line, to obtain a Tanner graph.

FIG. 3 is a Tanner graph of an LDPC check matrix H.

As shown in FIG. 3, the Tanner graph represents the LDPC check matrix. For example, for the check matrix H with a size of m rows and n columns, the Tanner graph includes two types of nodes: n variable nodes and m check nodes. The n variable nodes respectively correspond to the n columns of the check matrix H, and the m check nodes respectively correspond to the m rows of the check matrix H. A cycle in the Tanner graph consists of connected vertices. The cycle uses one of the vertices as both a start point and an end point, and passes through each node only once. A length of the cycle is defined as a quantity of connection lines included in the cycle. A girth of a graph may also be referred to as a size of the graph, and is defined as a smallest cycle length in the graph. In FIG. 3, a girth is 4, as shown by bold connection lines in FIG. 3. The variable nodes in the Tanner graph each correspond to one column of the check matrix H, that is, correspond to one LDPC codeword bit. The check nodes in the Tanner graph each correspond to one row of the check matrix H, that is, correspond to one LDPC parity bit. Whether there is a connection between the two types of nodes corresponds to a value of an element in the matrix H. If there is a connection between an i^{th} check node and a j^{th} variable node, it indicates that a value of an element (i, j) in the matrix H is 1. If there is no connection between them, the value of the element is 0. A connection line between the variable node and the check node may also be referred to as an edge. That there is the connection between the check node and the variable node may also be described as that there is a connection or an edge between the check node and the variable node. An edge relationship between the check node and the variable node may include two cases: there is an edge or there is no edge.

In addition, in the Tanner graph, the cycle (cycle) is a closed loop formed by connecting variable nodes, check nodes, and edges end to end.

As described above, the LDPC code is a linear block code. In the linear block code, a to-be-encoded information sequence is divided into groups in a unit of q bits, and an encoder performs a linear operation on the q information bits to obtain m parity bits. Then, the q information bits are combined with the m parity bits to obtain a codeword whose length is n = q + m. A mapping relationship between the q information bits and the codeword whose length is n bits is usually represented by a corresponding check matrix H. A code bit sequence may be correspondingly generated based on the check matrix H to complete an encoding process. After the codeword sequence is transmitted through a channel, a receive-end device correspondingly decodes a received signal, to determine an original information bit.

### 2. QC-LDPC code

A quasi-cyclic low-density parity-check (quasi-cyclic low density parity check, QC-LDPC) code is a type of structured LDPC code. Due to a unique structure of a check matrix of the QC-LDPC code, a simple feedback shift register can be used for encoding, to reduce encoding complexity of the LDPC code. An LDPC code with a large code length has an extremely large check matrix H. Therefore, H is usually represented by blocks: The complete check matrix H is considered to be generated from a plurality of Z_{c} × Z_{c} submatrices. Specifically, the complete check matrix H may be represented by a base matrix H_{b}. Each element in H_{b} corresponds to one Z_{c} × Z_{c} submatrix. Each submatrix may be represented by a quantity of cyclic shift bits. Therefore, storage space needed by the complete check matrix H is greatly reduced. An element in the base matrix H_{b} may also be referred to as a QC block.

Based on the base matrix H_{b} and a lifting size Z_{c} (lifting size), the base matrix H_{b} may be extended to the complete check matrix for encoding or decoding. Z_{c} may also be referred to as an extension factor, a lifting factor, an extension value, an extension coefficient, a lifting value, or the like.

For example, the base matrix H_{b} of the QC-LDPC code is as follows: $\left[\begin{matrix}13 & 48 & 80 & 66 & 4 & 74 & 7 & 30 & 76 & 52 & 37 & 60 & - 1 & 49 & - 1 & 73 & 31 & 74 & 73 & 23 & 1 & 0 & - 1 & - 1 \\ 69 & 63 & 74 & 56 & 64 & 77 & 57 & 65 & 6 & 16 & 51 & - 1 & 64 & - 1 & 64 & 68 & 9 & 48 & 62 & 54 & - 1 & 0 & 0 & - 1 \\ 51 & 15 & 0 & 80 & 24 & 25 & 42 & 54 & 44 & 71 & 71 & 9 & 67 & 35 & 67 & - 1 & 58 & - 1 & 29 & - 1 & 0 & - 1 & 0 & 0 \\ 16 & 29 & 36 & 41 & 44 & 56 & 59 & 37 & 50 & 24 & - 1 & 65 & 4 & 65 & 4 & 52 & - 1 & 4 & - 1 & 73 & 1 & - 1 & - 1 & 0\end{matrix}\right]$

It can be learned that the base matrix H_{b} has a size of 4 rows and 24 columns. Each element in the base matrix H_{b} represents a Z_{c}-order square matrix. An element ${P}_{{Z}_{c}}^{i}$ represents a circulant permutation matrix. i represents a cyclic shift value. i is an integer. In addition, in the base matrix H_{b}, "-1" represents an all-zero matrix, and "0" represents an identity matrix.

For example, ${P}_{{Z}_{c}}^{1}$ is as follows: ${P}_{{Z}_{c}}^{1} = \left[\begin{matrix}0 & 1 & 0 & … & 0 \\ 0 & 0 & 1 & … & 0 \\ ⋮ & ⋮ & ⋮ & ⋱ & ⋮ \\ 0 & 0 & 0 & … & 1 \\ 1 & 0 & 0 & … & 0\end{matrix}\right]$

Optionally, a zero element in the base matrix H_{b} may alternatively be represented in a form other than "-1". For example, "-" or a null value is used to represent an all-zero matrix.

It should be noted that the base matrix may also be referred to as a base graph (base graph, BG). The following describes embodiments of this application by using the base matrix.

### 3. Non-zero element and zero element

In a check matrix, a zero element represents that there is no connection between a variable node and a check node, and a non-zero element represents that there is a connection between the variable node and the check node.

In an LDPC base matrix, a zero element represents a Z_{c}-order all-zero square matrix, and a non-zero element represents a Z_{c}-order identity matrix or a circulant permutation matrix based on the Z_{c}-order identity matrix. A value of the non-zero element represents a cyclic shift value or a shifting value (shifting value) relative to the identity matrix.

Specific representation forms of the zero element and the non-zero element are not limited in this application. For example, in the check matrix H shown in FIG. 2, a zero element is represented by "0", and a non-zero element is represented by "1". For another example, in the foregoing base matrix H_{b}, a zero element is represented by "-1", and a non-zero element is represented by a "non-negative value".

For ease of description, a zero element is represented by "0" and a non-zero element is represented by "1" below.

### 4. Column weight and row weight

For a column of a matrix, a column weight may be a quantity of non-zero elements included in the column. For a row of the matrix, a row weight may be a quantity of non-zero elements included in the row. For example, as shown in FIG. 2, in the check matrix H, a column weight of a 1^{st} column is 2, and a row weight of a 1^{st} row is 4. For another example, in the foregoing base matrix H_{b}, a column weight of a 1^{st} column is 4, and a row weight of a 1^{st} row is 20.

### 5. Structure of a check matrix

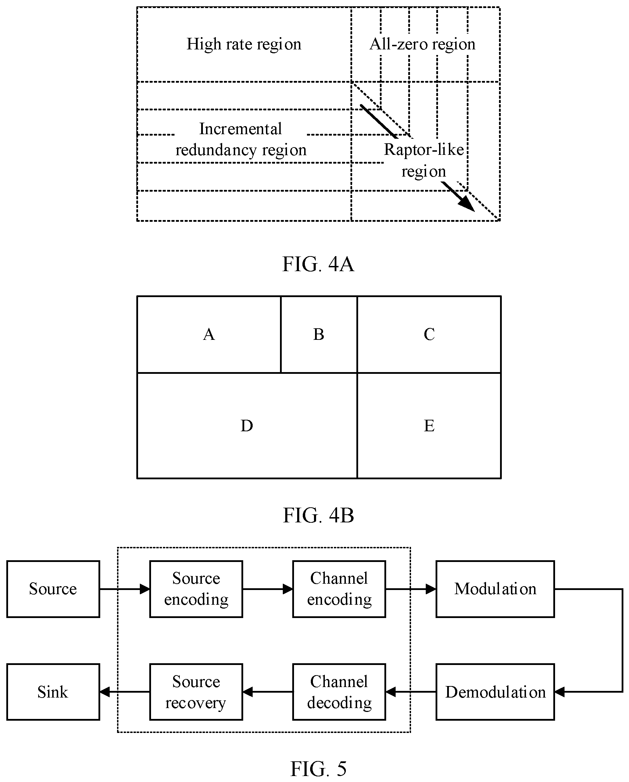

FIG. 4A and FIG. 4B are diagrams of a structure of a check matrix.

As shown in FIG. 4A, the check matrix may include a high rate region (high rate region), an all-zero region, an incremental redundancy region (incremental redundancy region), and a raptor-like region (raptor-like region). The high rate region may include a part A and a part B shown in FIG. 4B. The part A corresponds to an information bit (also referred to as an information bit position, a systematic bit, or the like), and the part B is a square matrix and corresponds to a core parity bit (also referred to as a core check bit). The all-zero region may correspond to a part C in FIG. 4B, and is an all-zero matrix. The incremental redundancy region (incremental redundancy region) may correspond to a part D in FIG. 4B. The raptor-like region may correspond to a part E in FIG. 4B, may be an identity matrix, and corresponds to a parity bit extended at a low code rate.

The check matrix of the LDPC code shown in FIG. 4A and FIG. 4B uses a "raptor-like" structure, and may be gradually extended to a low code rate through a core matrix with a high code rate. In actual use, as shown in FIG. 4A, first X rows and first Y columns of the check matrix may be intercepted. As code rates are in descending order, X and Y gradually increase, and a region in which the matrix is used also gradually increases.

It should be noted that the check matrix may be represented by an LDPC base matrix. Therefore, a structure of the LDPC base matrix is similar to the structure of the check matrix, and details are not described herein again.

### 6. Information column and check column

Columns of an LDPC base matrix consist of an information column and a check column.

The information column corresponds to an information bit (also referred to as an information bit position, a systematic bit, or the like), and is a column corresponding to a part A.

The check column corresponds to a parity bit (or a check bit or the like), and may include a core check column and an extended check column. The core check column is a column corresponding to a part B. The extended check column is a column corresponding to a part C or a part E. The extended check column may also be referred to as a raptor-like column. The extended check column corresponds to an extended node.

### 7. Core row, core column, and core matrix

A core row of an LDPC base matrix is a row corresponding to a core parity bit. In other words, the core row is a row corresponding to a high rate region, or a row corresponding to a part A, a part B, or a part C.

A core column may include all information columns and all core check columns. In other words, the core column is a column corresponding to the high rate region, or a column corresponding to the part A and the part B.

A core matrix (Kernel Matrix) is a matrix region formed by all core rows and all core columns of the LDPC base matrix. In other words, the core matrix is the high rate region of the LDPC base matrix, or a part consisting of the part A and the part B.

### 8. Information transmission procedure

FIG. 5 is a diagram of an information transmission procedure. As shown in FIG. 5, information is sent by a source, and after processing such as source encoding, channel encoding, modulation, air interface transmission, demodulation, channel decoding, and source recovery, the information reaches a sink, so that transmission of the information from the source to the sink is completed. In FIG. 5, processing (including the source encoding, the channel encoding, the modulation, and the like) shown at an upper layer is performed at a transmit-end device, and processing (including the demodulation, the channel decoding, the source recovery, and the like) shown at a lower layer is performed at a receive-end device. Embodiments of this application mainly relate to the source encoding, the channel encoding, the channel decoding, and the source recovery shown in FIG. 5.

### 9. Conventional extension and split extension

Conventional extension is also referred to as normal extension, and is low-code-rate extension performed based on a conventional manner. In this manner, a row of a storage matrix is read as a row of an LDPC base matrix.

Split extension differs from conventional extension in that when a row of the storage matrix is read as a newly added row of the LDPC base matrix, the newly added row is further used to perform elimination on a row preceding the newly added row in the LDPC base matrix, and parts other than an extended node in a row obtained after the elimination and the newly added row are orthogonal. This may also be understood as that the row on which the elimination is performed is split into the newly added row and the row obtained after the elimination. The row obtained after the elimination may correspond to a parent node. The newly added row, also referred to as an elimination row, may correspond to a child node.

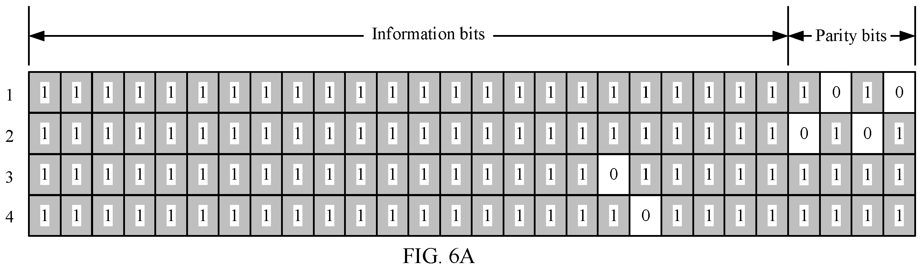

FIG. 6A to FIG. 6C show an example of conventional extension and split extension.

An example in which split extension is performed on a 2^{nd} row is used in FIG. 6A to FIG. 6C.

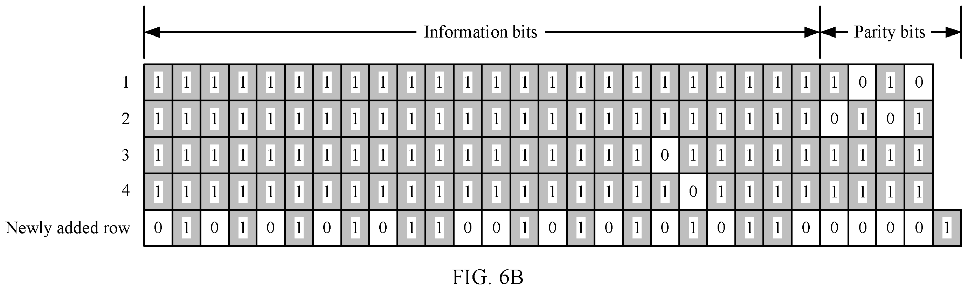

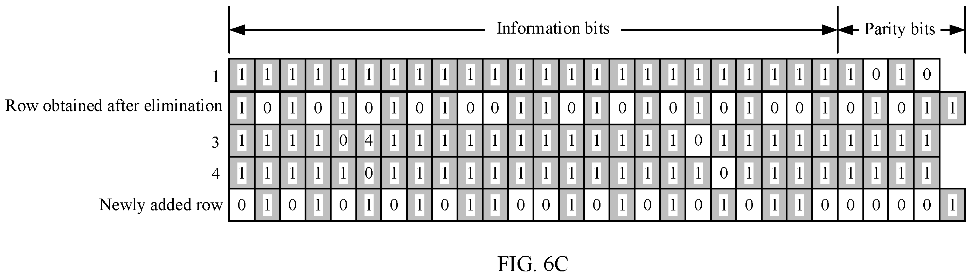

FIG. 6A shows a matrix before extension. FIG. 6B shows a matrix obtained after a row is added. From FIG. 6A to FIG. 6B, conventional extension is performed. FIG. 6C shows a matrix obtained after elimination is performed on the 2^{nd} row with the added row. From FIG. 6A to FIG. 6B and then to FIG. 6C, split extension is performed. Parts other than a last column in a row obtained after the elimination and the newly added row are orthogonal.

In a current LDPC code, there is low orthogonality between rows of an LDPC base matrix, resulting in impact on decoding efficiency and performance. For example, a high-code-rate part of an NR LDPC code has a high edge density, and supports only parallel decoding of QC blocks. For another example, in an LDPC code based on split extension shown in FIG. 6A to FIG. 6C, parts other than an extended node in the row obtained after the elimination and the newly added row are orthogonal. However, there are overlapping elements at the extended node, and staggering, a change in a message transfer manner, or the like is needed to implement parallel decoding of rows, resulting in impact on decoding efficiency and performance.

In view of the foregoing problem, this application provides an LDPC code-based communication method and a communication apparatus, to improve decoding efficiency and performance.

The following describes method embodiments of this application.

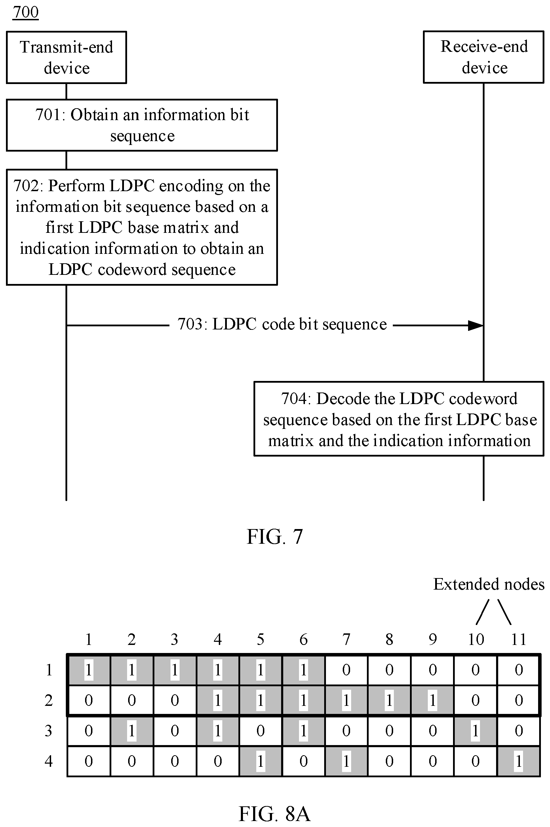

FIG. 7 is a schematic flowchart of an LDPC code-based communication method 700 according to this application.

The method 700 may be performed by a transmit-end device and a receive-end device. Unless otherwise specified, the "transmit-end device" or the "receive-end device" may be the transmit-end device or the receive-end device, or may be an apparatus that can support the transmit-end device or the receive-end device in implementing the function. For ease of description, the following uses the transmit-end device and the receive-end device for description. The transmit-end device may be a terminal device or a network device. The receive-end device may be a terminal device or a network device.

The method 700 may include at least a part of the following content.

Step 701: The transmit-end device obtains an information bit sequence.

To be specific, if the transmit-end device needs to communicate with the receive-end device, in other words, the transmit-end device needs to send a signal to the receive-end device, the transmit-end device needs to first obtain an information bit sequence corresponding to the signal that needs to be sent to the receive-end device.

That the transmit-end device obtains the information bit sequence may mean that the transmit-end device performs source encoding on a source symbol to generate the information bit sequence. Alternatively, that the transmit-end device obtains the information bit sequence may mean that the transmit-end device receives the information bit sequence from another communication apparatus.

Step 702: The transmit-end device performs LDPC encoding on the information bit sequence based on a first LDPC base matrix and indication information to obtain an LDPC codeword sequence.

The first LDPC base matrix may be a matrix stored in the transmit-end device or a matrix predefined in a protocol. The indication information may indicate a correlation between rows in the first LDPC base matrix.

The transmit-end device may determine a second LDPC base matrix based on the first LDPC base matrix and the indication information, and perform LDPC encoding on the information bit sequence by using the second LDPC base matrix, to obtain the LDPC codeword sequence. The second LDPC base matrix is a matrix actually used by the transmit end for encoding. In a process of obtaining the second LDPC base matrix, a low-code-rate extension manner may be split extension, or may be a hybrid of split extension and conventional extension. In a low-code-rate extension process, whether each extension is conventional extension or split extension may be determined by the indication information. For descriptions of split extension and conventional extension, refer to the foregoing descriptions. Details are not described herein again.

In a possible implementation, the indication information may include first information. The first information corresponds to split extension. Optionally, the indication information further includes second information. The second information corresponds to conventional extension. When the indication information does not include the first information, in the process of obtaining the second LDPC base matrix, the low-code-rate extension manner is split extension. When the indication information includes both the first information and the second information, in the process of obtaining the second LDPC base matrix, the low-code-rate extension manner is the hybrid of split extension and conventional extension.

The following describes the first information and the second information.

The first information indicates a plurality of row pairs. Each row pair in the plurality of row pairs includes a first row and a second row. A set of column numbers of columns in which non-zero elements in first x elements of a first row in a row pair are located is a proper subset of a set of column numbers of columns in which non-zero elements in first x elements of a second row in the row pair are located. x is a positive integer. For example, x is equal to a quantity of core columns in the first LDPC base matrix. In other words, in a core column part of a row pair, a set of column numbers of columns in which non-zero elements in a first row are located is a proper subset of a set of column numbers of columns in which non-zero elements in a second row are located. That the set of the column numbers of the columns in which the non-zero elements in the first row are located is the proper subset of the set of the column numbers of the columns in which the non-zero elements in the second row are located may also be described as that connection relationships, edges, or the non-zero elements other than an extended node in the first row are properly included in connection relationships, edges, or the non-zero elements other than an extended node in the second row. A shifting value of the non-zero element in the first row and a shifting value of the non-zero element at a corresponding position in the second row may be the same, or may differ by a constant value. This is not limited.

For example, in a row pair, a first row is {1, 0, 0, 3, 0, 5, 0, 0, 1, 0}, and a second row is {1, 0, 2, 3, 4, 5, 0, 1, 0, 0}. First seven columns are core columns. Last three columns correspond to extended nodes. 0 represents a zero element. In the first seven columns, a set of column numbers of columns in which non-zero elements in the first row are located is {1, 4, 6}. A set of column numbers of columns in which non-zero elements in the second row are located is {1, 3, 4, 5, 6}. {1, 4, 6} is a proper subset of {1, 3, 4, 5, 6}, which may also be described as that {1, 0, 0, 3, 0, 5, 0} is properly included in {1, 0, 2, 3, 4, 5, 0}.

A storage manner of a first row and a second row in a row pair is not limited in embodiments of this application. In a possible implementation, each row pair in the plurality of row pairs corresponds to two rows in the first LDPC base matrix or is two rows in the first LDPC base matrix. In other words, the second row may correspond to a row in the first LDPC base matrix or is a row in the first LDPC base matrix, and the first row may correspond to a row in the first LDPC base matrix or is a row in the first LDPC base matrix. In this case, each row pair in the plurality of row pairs is two rows in a same base matrix. In another possible implementation, the second row may correspond to a row in the first LDPC base matrix or is a row in the first LDPC base matrix, and the first row may correspond to a row in a matrix other than the first LDPC base matrix or is a row in a matrix other than the first LDPC base matrix. In other words, the first row and the second row in each row pair in the plurality of row pairs are stored in different base matrices. The following describes embodiments of this application by using an example in which each row pair in the plurality of row pairs corresponds to two rows in the first LDPC base matrix or is two rows in the first LDPC base matrix.

In the process of obtaining the second LDPC base matrix, for a first row and a second row in a row pair, a row that is of the second LDPC base matrix and that corresponds to the first row is the same as the first row. In other words, the row that is of the second LDPC base matrix and that corresponds to the first row of the first LDPC base matrix is obtained by directly reading the first row of the first LDPC base matrix. A row that is of the second LDPC base matrix and that corresponds to the second row is obtained by performing elimination on the corresponding second row with the first row of the first LDPC base matrix. In this way, parts other than an extended node in the row that is of the second LDPC base matrix and that corresponds to the first row and the corresponding row that corresponds to the second row are orthogonal. It should be noted that, that the row that is of the second LDPC base matrix and that corresponds to the first row is the same as the first row should be understood as that when the row that is of the second LDPC base matrix and that corresponds to the first row is initially obtained, the row that is of the second LDPC base matrix and that corresponds to the first row is the same as the first row; and if split extension is subsequently performed with the row that is of the second LDPC base matrix and that corresponds to the first row as a parent node, the row is no longer the same as the first row of the first LDPC base matrix.

The second information indicates one or more third rows. The one or more third rows are used for conventional extension. In the process of obtaining the second LDPC base matrix, rows that are of the second LDPC base matrix and that correspond to the one or more third rows are the same as the one or more third rows of the first LDPC base matrix. In other words, the row that is of the second LDPC base matrix and that corresponds to the third row of the first LDPC base matrix is obtained by directly reading the third row of the first LDPC base matrix. Similarly, that the row that is of the second LDPC base matrix and that corresponds to the third row is the same as the third row of the first LDPC base matrix should be understood as that when the row that is of the second LDPC base matrix and that corresponds to the third row is initially obtained, the row that is of the second LDPC base matrix and that corresponds to the third row is the same as the third row of the first LDPC base matrix; and if split extension is subsequently performed with the row that is of the second LDPC base matrix and that corresponds to the third row as a parent node, the row is no longer the same as the third row of the first LDPC base matrix.

A specific form of the indication information is not limited in embodiments of this application. For example, a form used for the indication information may include at least one of a sequence, a mapping table, or a mapping pair.

The following describes the indication information in the following two cases by using an example in which the indication information is in a form of a sequence: the second information is included and the second information is not included.

Case 1: The indication information does not include the second information.

The indication information does not include the second information. In other words, the second LDPC base matrix is obtained through split extension. In this case, the sequence corresponding to the indication information may be referred to as a split sequence (split sequence). The split sequence may consist of a row number of a core row and a row number of the second row in each of the foregoing one or more row pairs. A length of the split sequence may be equal to a quantity of rows of the second LDPC base matrix. In a row pair, a position of a row number of a second row in the split sequence is a row number of a first row, and the position of the row number of the second row in the split sequence is greater than the row number of the first row. For example, if a value at an 8^{th} position in the split sequence is 3, it indicates that the row pair is an 8^{th} row and a 3^{rd} row, the 8^{th} row corresponds to the first row, and the 3^{rd} row corresponds to the second row. During split extension, the transmit-end device performs elimination on the 3^{rd} row with the 8^{th} row.

In a possible implementation, a sequence corresponding to the first information may include one or more segments. Row numbers in a *t^{th}* segment of the one or more segments are a permutation form of {1, 2,..., 2^{*t*-1} M - 1, 2^{*t*-1}M}. *t* and M are positive integers. Each segment in the one or more segments corresponds to one round of splitting. For example, the split sequence may be {1, 2, 3, 4, 3, 4, 1, 2, 5, 2, 6, 8, 4, 7, 1, 3}. M is 4. A part starting from the 5^{th} element is the sequence corresponding to the first information. In other words, the sequence corresponding to the first information is {3, 4, 1, 2, 5, 2, 6, 8, 4, 7, 1, 3}. *t* is 2. {3, 4, 1, 2} is a 1^{st} segment, and {5, 2, 6, 8, 4, 7, 1, 3} is a 2^{nd} segment. The 1^{st} segment {3, 4, 1, 2} is a permutation form of {1, 2,..., 2¹⁻¹ × 4 - 1,2¹⁻¹ × 4} = {1, 2, 3, 4}. The 2^{nd} segment {5, 2, 6, 8, 4, 7, 1, 3} is a permutation form of {1, 2,..., 2²⁻¹ × 4 - 1,2²⁻¹ × 4} = {1, 2, 3, 4, 5, 6, 7, 8}.

For example, M is a quantity of core rows of the first LDPC base matrix. In other words, the core rows of the first LDPC base matrix may be split. This is because a core region has a high edge density, and a corresponding core check equation usually lacks orthogonality. Orthogonality of a core region of the second LDPC base matrix is improved through split extension. In this case, specific features of the split sequence may be as follows:
(1) If a row *i* is generated by splitting a row *j, j = f*(*i*)*,* the j is a parent node of the row *i,* and the row *i* is a child node of the row*j*.
(2) If a row *i* = *i*₀*, i*₁*, i₂*,..., *iₗ* = *j* exists such that *iₖ* = *f*(*i*_{*k-*1}) holds *for k =* 1*,..., l, i~j,* where *l* is a positive integer.
(3) For an *i*^{th} element in the split sequence, a set *Sᵢ =* {*j* ≤ *i* | *i~j*} is defined.
(4) If a set of core rows of a core matrix is *C*₀, the row *i* ∈ *Sⱼ*, where the row *j* ∈ *C*₀*.*
(5) Each round of splitting is complete splitting, that is, splitting is performed on *C*₀ and all current child nodes.

That each round of splitting is complete splitting may mean that the split sequence includes one or more segments, and each segment corresponds to one round of splitting. Row numbers in a segment corresponding to a *t*^{th} round of splitting are a permutation form of {1,..., 2^{*t*-1}|*C*₀|}. *t* is a positive integer. |*C*₀| is a quantity of elements in the set *C*₀, namely, the quantity of core rows, and may correspond to M above.

In the foregoing implementation, each row number appears only once in one round of splitting. Therefore, a plurality of splits included in each round can be performed in parallel, to help improve splitting efficiency.

Case 2: The indication information includes the first information and the second information.

The indication information includes the first information and the second information. In other words, the second LDPC base matrix is obtained through the hybrid of split extension and conventional extension. In this case, the indication information may further include third information. The third information indicates one or more fourth rows. The one or more fourth rows of the second LDPC base matrix are the same as the one or more fourth rows of the first LDPC base matrix. Similarly, that the row that is of the second LDPC base matrix and that corresponds to the fourth row is the same as the fourth row of the first LDPC base matrix should be understood as that when the row that is of the second LDPC base matrix and that corresponds to the fourth row is initially obtained, the row that is of the second LDPC base matrix and that corresponds to the fourth row is the same as the fourth row of the first LDPC base matrix; and if split extension is subsequently performed with the row that is of the second LDPC base matrix and that corresponds to the fourth row as a parent node, the row is no longer the same as the fourth row of the first LDPC base matrix.

In this case, a length of the sequence corresponding to the indication information may be equal to a quantity of rows of the second LDPC base matrix. The sequence corresponding to the indication information is referred to as an indication sequence for short below.

The first information may include a row number of the second row in each of the foregoing one or more row pairs. In a row pair, a position of a row number of a second row in the indication sequence is a row number of a first row, and the position of the row number of the second row in the indication sequence is greater than the row number of the first row. For example, if a value at an 8^{th} position in the indication sequence is 3, it indicates that the row pair is an 8^{th} row and a 3^{rd} row, the 8^{th} row corresponds to the first row, and the 3^{rd} row corresponds to the second row. During split extension, the transmit-end device performs elimination on the 3^{rd} row with the 8^{th} row.

The second information includes one or more first characters. Positions of the one or more first characters in the indication sequence correspond to row numbers of the one or more third rows. For example, if a 7^{th} position in the indication sequence is the first character, it indicates that a row that is of the second LDPC base matrix and that corresponds to a 7^{th} row of the first LDPC base matrix is obtained based on conventional extension. In other words, the row that is of the second LDPC base matrix and that corresponds to the 7^{th} row of the first LDPC base matrix is the same as the 7^{th} row of the first LDPC base matrix.

For example, the first character is a value other than a row number of the first LDPC base matrix.

The third information includes M second characters or M row numbers. The M row numbers are 1, 2, ..., and M. M is a positive integer. For example, M is a quantity of core rows of the first LDPC base matrix. Positions of the M second characters in the indication sequence correspond to row numbers of the one or more fourth rows. For example, if a 2^{nd} position in the indication sequence is the second character, it indicates that a row that is of the second LDPC base matrix and that corresponds to a 2^{nd} row of the first LDPC base matrix is the same as the 2^{nd} row of the first LDPC base matrix.

For example, the second character is a value other than a row number of the first LDPC base matrix. The second character and the first character may be the same or different. This is not limited.

In a possible implementation, the indication sequence may be of a segment structure. In an example, the indication sequence may sequentially include a first segment, a second segment, a third segment, a fourth segment, and a fifth segment. The first segment consists of the third information. The second segment consists of a first part of the second information. The third segment consists of a first part of the first information. The fourth segment consists of a second part of the first information and a second part of the second information. The fifth segment consists of a third part of the second information. In another example, the indication sequence may sequentially include a first segment, a second segment, a third segment, and a fourth segment. The first segment consists of the third information. The second segment consists of a first part of the second information. The third segment consists of a first part of the first information. The fourth segment consists of a second part of the first information and a second part of the second information.

Optionally, the third segment included in the indication sequence may include one or more sub-segments. Row numbers in an *r^{th}* segment of the one or more sub-segments are a permutation form of {1, 2, ..., 2^{*r*-1}(M + T) - 1, 2^{*r*-1}(M + T)}. *r* is a positive integer. T is a quantity of characters in the first part of the second information. For detailed descriptions, refer to the sequence corresponding to the first information.

The following provides a general form of the indication sequence by using an example in which the indication sequence sequentially includes the first segment, the second segment, the third segment, the fourth segment, and the fifth segment.

The first character is denoted as 0. A quantity of the core rows of the core matrix is denoted as M. The indication sequence *θ* may be expressed as follows: $θ = \left\{\begin{matrix}1 , … , M \\ {0}_{1 \times T} \\ {p}_{1} \left(1,…,M+T\right) , {p}_{2} \left(1,…,2M+2T\right) … \\ γ \left(0, {p}_{x}\right) \\ {0}_{1 \times T ′}\end{matrix}\right.$

It can be learned that the indication sequence is a five-segment piecewise function. The first segment 1,..., *M* is a core segment, and corresponds to the core matrix (or a core check equation) of the first LDPC base matrix. The second segment 0_{1×*T*} is a conventional extension segment, and corresponds to conventional extension (or a conventional extension check equation). The second segment consists of the first character 0. The third segment *p*₁(1,..., *M* + *T), p*₂(1,..., 2M + 2T) ... is a split extension segment, corresponds to split extension, and consists of a row number (this segment definitely includes a row number of the core matrix). The fourth segment *γ*(0, *pₓ*) is a hybrid segment of split extension and conventional extension. The fourth segment indicates that the first character 0 is interleaved with a row number that appears before. The fifth segment also corresponds to conventional extension. The fifth segment consists of the first character 0. *T* is a length of the second segment, namely, a quantity of characters. *T*' is a length of the fifth segment, namely, a quantity of characters.

In a possible implementation, each segment of the indication sequence may be determined based on a code rate or a row number. For example, if the indication sequence includes the first segment, the second segment, the third segment, the fourth segment, and the fifth segment, a sequence position *jᵢ* exists such that 1 ≤ j < *j*₁ corresponds to the first segment, *j*₁ ≤ j <*j*₂ corresponds to the second segment, ..., until the last segment is *j*₄ ≤ *j.*

In a possible implementation, *jᵢ* is related to a code rate corresponding to the sequence (a quantity of rows of a check equation). To be specific, a threshold *Rᵢ* related to the code rate exists such that ${j}_{i} = \frac{K}{{R}_{i}} + P - K$ is the segment position described above. P is a quantity of punctured columns. *K* is a quantity of information columns.

The foregoing describes low-code-rate extension in embodiments of this application with reference to the indication information. It can be learned from the foregoing that in a split extension process, only parts of the row obtained after the elimination and the newly added row are orthogonal, and there are still overlapping elements at the extended node. To further improve orthogonality between rows, an association relationship between child nodes may be designed in embodiments of this application. Details are described below.

As described above, the first information may indicate one or more row pairs. In a row pair, a set of column numbers of columns in which non-zero elements in first x elements of a first row are located is a proper subset of a set of column numbers of columns in which non-zero elements in first x elements of a second row are located. x is a positive integer.

Further, in embodiments of this application, the plurality of first rows indicated by the first information may form one or more row groups. Each row group in the one or more row groups includes at least two of the first rows. A column weight of each column in a matrix region, a subgraph, or a matrix of the second rows corresponding to the at least two first rows is less than or equal to 2. The at least two first rows have an association relationship.

For example, the row pairs indicated by the first information include {(6, 1), (7, 4), (8, 3), (9, 2), (10, 5)}, and the first rows indicated by the first information include rows 6, 7, 8, 9, and 10. The rows 6, 7, and 8 are a row group, and the rows 9 and 10 are a row group. A column weight of each column in a matrix region, a subgraph, or a matrix formed by rows 1, 4, and 3 corresponding to the rows 6, 7, and 8 is less than or equal to 2. The rows 6, 7, and 8 have an association relationship. A column weight of each column in a matrix region, a subgraph, or a matrix formed by rows 2 and 5 corresponding to the rows 9 and 10 is less than or equal to 2. The rows 9 and 10 have an association relationship.

The association relationship may include a first association relationship and/or a second association relationship. The first association relationship and the second association relationship are relationships between two first rows. The two first rows having the first association relationship are orthogonal to each other. A union set of column numbers of columns in which non-zero elements of the two first rows are located includes an intersection set of column numbers of columns in which non-zero elements of the two second rows corresponding to the two first rows are located. The two first rows having the first association relationship herein may be any two first rows having the first association relationship in a row group. The two first rows having the second association relationship have a same connection edge at a first position. A column number of the first position belongs to an intersection set of column numbers of columns in which non-zero elements of the two second rows corresponding to the two first rows are located. The two first rows having the second association relationship herein may be any two first rows having the second association relationship in a row group.

FIG. 8A to FIG. 8D are diagrams of the first association relationship.

In FIG. 8A to FIG. 8D, a 1^{st} row and a 2^{nd} row correspond to the second rows. A column weight of each column in a matrix region (or a matrix or a subgraph) formed by the 1^{st} row and the 2^{nd} row is not greater than 2. A 3^{rd} row and a 4^{th} row correspond to the first rows. The 1^{st} row and the 3^{rd} row are a row pair. The 2^{nd} row and the 4^{th} row are a row pair. A 10^{th} column and an 11^{th} column of each row correspond to extended nodes.

As shown in FIG. 8A, the 3^{rd} row and the 4^{th} row are orthogonal to each other. In other words, a column weight of each column in a matrix region formed by the 3^{rd} row and the 4^{th} row is less than or equal to 1.

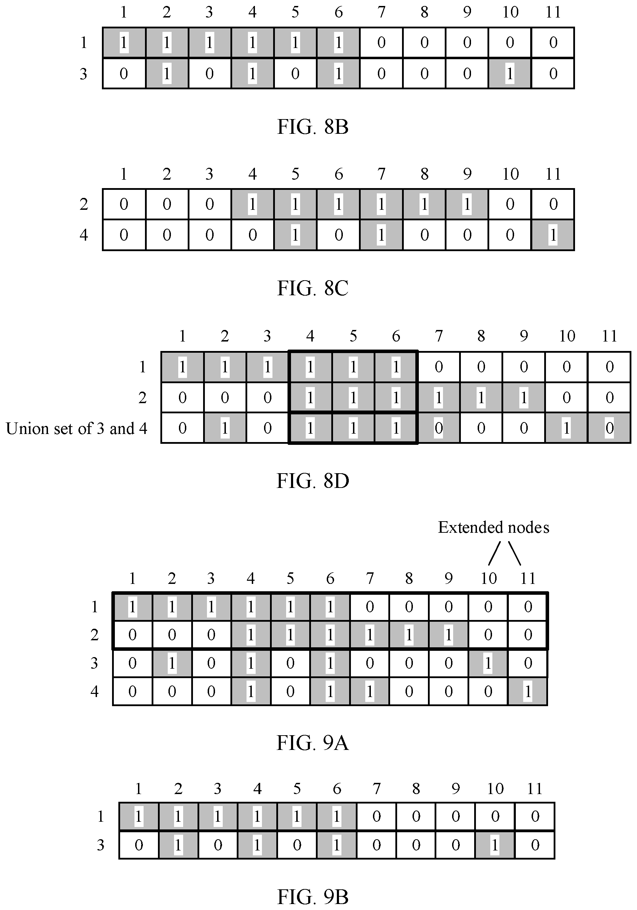

As shown in FIG. 8B, a set of column numbers of columns in which non-zero elements in a part other than the extended nodes in the 1^{st} row are located is {1, 2, 3, 4, 5, 6}, and a set of column numbers of columns in which non-zero elements in a part other than the extended nodes in the 3^{rd} row are located is {2, 4, 6}. {1, 2, 3, 4, 5, 6} properly includes {2, 4, 6}. In other words, {2, 4, 6} is a proper subset of {1, 2, 3, 4, 5, 6}.

As shown in FIG. 8C, a set of column numbers of columns in which non-zero elements in a part other than the extended nodes in the 2^{nd} row are located is {4, 5, 6, 7, 8, 9}, and a set of column numbers of columns in which non-zero elements in a part other than the extended nodes in the 4^{th} row are located is {5, 7}. {4, 5, 6, 7, 8, 9} properly includes {5, 7}. In other words, {5, 7} is a proper subset of {4, 5, 6, 7, 8, 9}.

As shown in FIG. 8D, an intersection set of a set {1, 2, 3, 4, 5, 6} of column numbers of columns in which non-zero elements in the 1^{st} row are located and a set {4, 5, 6, 7, 8, 9} of column numbers of columns in which non-zero elements in the 2^{nd} row are located is {4, 5, 6}, and a union set of a set {2, 4, 6, 10} of column numbers of columns in which non-zero elements in the 3^{rd} row are located and a set {5, 7, 11} of column numbers of columns in which non-zero elements in the 4^{th} row are located is {2, 4, 5, 6, 7, 10, 11}. {2, 4, 5, 6, 7, 10, 11} includes {4, 5, 6}. In this way, the 3^{rd} row and the 4^{th} row have the first association relationship.

FIG. 9A to FIG. 9D are diagrams of the second association relationship.

In FIG. 9A to FIG. 9D, a 1^{st} row and a 2^{nd} row correspond to the second rows. A column weight of each column in a matrix region (or a matrix or a subgraph) of the 1^{st} row and the 2^{nd} row is not greater than 2. A 3^{rd} row and a 4^{th} row correspond to the first rows. The 1^{st} row and the 3^{rd} row are a row pair. The 2^{nd} row and the 4^{th} row are a row pair. A 10^{th} column and an 11^{th} column of each row correspond to extended nodes.

As shown in FIG. 9B, a set of column numbers of columns in which non-zero elements in a part other than the extended nodes in the 1^{st} row are located is {1, 2, 3, 4, 5, 6}, and a set of column numbers of columns in which non-zero elements in a part other than the extended nodes in the 3^{rd} row are located is {2, 4, 6}. {1, 2, 3, 4, 5, 6} properly includes {2, 4, 6}. In other words, {2, 4, 6} is a proper subset of {1, 2, 3, 4, 5, 6}.

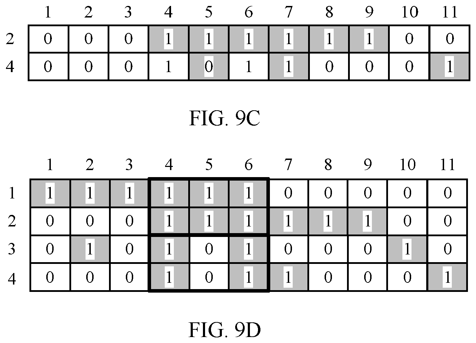

As shown in FIG. 9C, a set of column numbers of columns in which non-zero elements in a part other than the extended nodes in the 2^{nd} row are located is {4, 5, 6, 7, 8, 9}, and a set of column numbers of columns in which non-zero elements in a part other than the extended nodes in the 4^{th} row are located is {5, 7}. {4, 5, 6, 7, 8, 9} properly includes {5, 7}. In other words, {5, 7} is a proper subset of {4, 5, 6, 7, 8, 9}.

As shown in FIG. 9D, an intersection set of a set {1, 2, 3, 4, 5, 6} of column numbers of columns in which non-zero elements in the 1^{st} row are located and a set {4, 5, 6, 7, 8, 9} of column numbers of columns in which non-zero elements in the 2^{nd} row are located is {4, 5, 6}. In other words, the first position is a 4^{th} column, a 5^{th} column, and a 6^{th} column. The 4^{th} column, the 5^{th} column, and the 6^{th} column of the 3^{rd} row are the same as the 4^{th} column, the 5^{th} column, and the 6^{th} column of the 4^{th} row. In this way, the 3^{rd} row and the 4^{th} row have the second association relationship.

The following provides general forms of the first association relationship and the second association relationship with reference to the sequence *θ* corresponding to the indication information.

For *i* ≥ 1, if *θ*(*i*) > 0, *j* ≥ 1, exists, satisfying a condition *θ*(*j*) *>* 0. *θ*(*i*) ≠ *θ*(*j*)*. i* and *j* represent row numbers of child nodes. *θ*(*i*) and *θ*(*j*) represent row numbers of parent nodes.

For the first association relationship: *N(j)* ∩ *N(i) =* Ø and *N*(*θ*(*j*)) ∩ *N*(*θ*(*i*)) ⊆ *N*(*j*) ∪ *N*(*i*)*.*

For the second association relationship: [*N*(*θ*(*j*)) ∩ *N*(*θ*(*i*))] ∩ *N*(*i*) *=* [*N*(*θ*(*j*)) ∩ *N*(*θ*(*i*))] ∩ *N*(*j*) *.* [*N*(*θ*(*j*)) ∩ *N*(*θ*(*i*))] ∩ *N*(*i*) *=* [*N*(*θ*(*j*)) ∩ *N*(*θ*(*i*))] ∩ *N*(*j*) may be simplified to *N*(*θ*(*j*)) ∩ *N*(*i*) *= N*(*θ*(*i*)) ∩ *N*(*j*).

*N*(*i*) represents a set of column numbers of columns in which non-zero elements in a row whose row number is *i* are located. *N*(*j*) represents a set of column numbers of columns in which non-zero elements in a row whose row number is *j* are located. *N*(*θ*(*i*)) represents a set of column numbers of columns in which non-zero elements in a row whose row number is *θ*(*i*) are located. *N*(*θ*(*j*)) represents a set of column numbers of columns in which non-zero elements in a row whose row number is *θ*(*j*) are located.

The foregoing makes concepts of the parent node and the child node specific based on the sequence *θ*. In the foregoing description, *θ*(*i*) and *θ*(*j*) are parent nodes grouped together, and their correlation is reflected in their child nodes *i* and j. Alternatively, descriptions may be provided from a perspective of grouping parent nodes, and nodes whose child nodes have the first association relationship or the second association relationship belong to a group.

In embodiments of this application, in a row group of at least two first rows, every two of the first rows in the row group may form a combination. Each combination may have the first association relationship. Alternatively, each combination may have the second association relationship. Alternatively, at least one combination may have the first association relationship, and the other combinations may have the second association relationship. This is not limited.

In a possible implementation, in pairwise combinations of first rows in a row group, a quantity of combinations having the first association relationship and a quantity of combinations having the second association relationship are related to a quantity of the first rows included in the row group.

In an example, for a row group including *k* first rows, there are a total of $\left⌊\frac{k}{2}\right⌋ + 1$ allocation manners of a quantity of combinations having the first association relationship and a quantity of combinations having the second association relationship. In pairwise combinations of the first rows in the row group, $\left(\begin{matrix}k - i \\ 2\end{matrix}\right) + \left(\begin{matrix}i \\ 2\end{matrix}\right)$ combinations have the first association relationship, and $\left(\begin{matrix}k \\ 2\end{matrix}\right) - \left(\begin{matrix}k - i \\ 2\end{matrix}\right) - \left(\begin{matrix}i \\ 2\end{matrix}\right)$ combinations have the second association relationship. $0 \leq i \leq \left⌊\frac{k}{2}\right⌋$. $\left(\begin{matrix}k - i \\ 2\end{matrix}\right)$ represents a quantity of combinations of any two rows selected from *k - i* rows. $\left(\begin{matrix}k \\ 2\end{matrix}\right)$ represents a quantity of combinations of any two rows selected from *k* rows. $\left(\begin{matrix}i \\ 2\end{matrix}\right)$ represents a quantity of combinations of any two rows selected from *i* rows. └ ┘ represents rounding down. Specifically, the allocation manners of the quantity of combinations having the first association relationship and the quantity of combinations having the second association relationship may include: $\left(\begin{matrix}k \\ 2\end{matrix}\right) + \left(\begin{matrix}0 \\ 2\end{matrix}\right)$ combinations have the first association relationship and 0 combinations have the second association relationship, $\left(\begin{matrix}k - 1 \\ 2\end{matrix}\right) + \left(\begin{matrix}1 \\ 2\end{matrix}\right)$ combinations have the first association relationship and $\left(\begin{matrix}k \\ 2\end{matrix}\right) - \left(\begin{matrix}k - 1 \\ 2\end{matrix}\right) - \left(\begin{matrix}1 \\ 2\end{matrix}\right)$ combinations have the second association relationship, $\left(\begin{matrix}k - 2 \\ 2\end{matrix}\right) + \left(\begin{matrix}2 \\ 2\end{matrix}\right)$ combinations have the first association relationship and $\left(\begin{matrix}k \\ 2\end{matrix}\right) - \left(\begin{matrix}k - 2 \\ 2\end{matrix}\right) - \left(\begin{matrix}2 \\ 2\end{matrix}\right)$ combinations have the second association relationship, ..., and $\left(\begin{matrix}k - \left⌊\frac{k}{2}\right⌋ \\ 2\end{matrix}\right) + \left(\begin{matrix}\left⌊\frac{k}{2}\right⌋ \\ 2\end{matrix}\right)$ combinations have the first association relationship and $\left(\begin{matrix}k \\ 2\end{matrix}\right) - \left(\begin{matrix}k - \left⌊\frac{k}{2}\right⌋ \\ 2\end{matrix}\right) - \left(\begin{matrix}\left⌊\frac{k}{2}\right⌋ \\ 2\end{matrix}\right)$ combinations have the second association relationship.

For example, when *k* = 2, there are a total of $\left⌊\frac{k}{2}\right⌋ + 1 = \left⌊\frac{2}{2}\right⌋ + 1 = 2$ allocation manners of the quantity of combinations having the first association relationship and the quantity of combinations having the second association relationship. To be specific, either the two first rows have the first association relationship, or the two rows have the second association relationship.

For another example, when *k* = 3, there are a total of $\left⌊\frac{k}{2}\right⌋ + 1 = \left⌊\frac{3}{2}\right⌋ + 1 = 2$ allocation manners of the quantity of combinations having the first association relationship and the quantity of combinations having the second association relationship, including: $\left(\begin{matrix}3 - 0 \\ 2\end{matrix}\right) + \left(\begin{matrix}0 \\ 2\end{matrix}\right) = 3$ combinations have the first association relationship and $\left(\begin{matrix}3 \\ 2\end{matrix}\right) - \left(\begin{matrix}3 - 0 \\ 2\end{matrix}\right) - \left(\begin{matrix}0 \\ 2\end{matrix}\right) = 0$ combinations have the second association relationship, and $\left(\begin{matrix}3 - 1 \\ 2\end{matrix}\right) + \left(\begin{matrix}1 \\ 2\end{matrix}\right) = 1$ combination has the first association relationship and $\left(\begin{matrix}3 \\ 2\end{matrix}\right) - \left(\begin{matrix}3 - 1 \\ 2\end{matrix}\right) - \left(\begin{matrix}1 \\ 2\end{matrix}\right) = 2$ combinations have the second association relationship.

In another example, for a row group including k first rows, there are a total of $\left⌈\frac{k - 1}{2}\right⌉ + 1$ allocation manners of a quantity of combinations having the first association relationship and a quantity of combinations having the second association relationship. In pairwise combinations of the first rows in the row group, $\left(\begin{matrix}k - i \\ 2\end{matrix}\right) + \left(\begin{matrix}i \\ 2\end{matrix}\right)$ combinations have the first association relationship, and $\left(\begin{matrix}k \\ 2\end{matrix}\right) - \left(\begin{matrix}k - i \\ 2\end{matrix}\right) - \left(\begin{matrix}i \\ 2\end{matrix}\right)$ combinations have the second association relationship. $0 \leq i \leq \left⌈\frac{k - 1}{2}\right⌉$. $\left(\begin{matrix}k - i \\ 2\end{matrix}\right)$ represents a quantity of combinations of any two rows selected from *k - i* rows. $\left(\begin{matrix}k \\ 2\end{matrix}\right)$ represents a quantity of combinations of any two rows selected from *k* rows. $\left(\begin{matrix}i \\ 2\end{matrix}\right)$ represents a quantity of combinations of any two rows selected from *i* rows. ┌ ┐ represents rounding up.

In this way, for each row group in the one or more row groups, because the first rows in the row group have the first association relationship and/or the second association relationship, after split extension, rows that are of the second LDPC base matrix and that correspond to first rows in a row group and rows that are of the second LDPC base matrix and that correspond to second rows corresponding to the first rows in the row group are regrouped, so that rows in a same group are completely orthogonal to each other.

Step 703: The transmit-end device sends the LDPC codeword sequence to the receive-end device. In other words, the receive-end device receives the LDPC codeword sequence from the transmit-end device.

It should be noted that because a channel noise signal may be introduced in a process of transmitting the LDPC codeword sequence, the LDPC codeword sequence output or sent by the transmit-end device may be different from the LDPC codeword sequence received by the receive-end device.

Step 704: The receive-end device decodes the LDPC codeword sequence based on the first LDPC base matrix and the indication information.

The first LDCP base matrix and the indication information based on which the receive-end device performs decoding are the same as the first LDCP base matrix and the indication information based on which the transmit-end device performs encoding. For details, refer to the description on the transmit-end device side. Details are not described herein again.

In a possible implementation, the receive-end device may obtain the second LDPC base matrix based on the first LDPC base matrix and the indication information, and decode the LDPC codeword sequence based on the second LDPC base matrix. A row that is of the second LDPC base matrix and that corresponds to the first row is obtained by performing elimination on the second row in the same row pair as the first row.

It should be noted that a decoding matrix actually used by the receive-end device may be the same as or different from an encoding matrix actually used by the transmit-end device. For example, the transmit-end device may only read a corresponding row from the first LDPC base matrix based on the indication information without performing split extension, and the receive-end device may read the corresponding row from the first LDPC base matrix based on the indication information and perform split extension to obtain the second LDPC base matrix. In this case, the transmit-end device and the receive-end device use different LDPC base matrices. For another example, the transmit-end device obtains the second LDPC base matrix based on the first LDPC base matrix and the indication information and performs encoding by using the second LDPC base matrix, and the receive-end device also obtains the second LDPC base matrix in the same manner and performs decoding by using the second LDPC base matrix. In this case, the decoding matrix actually used by the receive-end device is the same as the encoding matrix actually used by the transmit-end device.

It should be noted that for each row group in the one or more row groups, the receive-end device may perform row-parallel decoding on rows in a same group obtained by grouping rows that are of the second LDPC base matrix and that correspond to first rows in a row group and rows that are of the second LDPC base matrix and that correspond to second rows corresponding to the first rows in the row group.

In a possible implementation, the receive-end device may perform row-parallel decoding on a part that is of the codeword sequence and that corresponds to rows in a first row set, and perform row-parallel decoding on a part that is of the codeword sequence and that corresponds to rows in a second row set. A union set of the first row set and the second row set includes rows that are of the second LDPC base matrix and that correspond to first rows in a row group and rows that are of the second LDPC base matrix and that correspond to second rows corresponding to the first rows in the row group. The first row set consists of rows that are of the second LDPC base matrix and that correspond to rows in a first subset and/or rows that are of the second LDPC base matrix and that correspond to rows in a second subset. The rows in the first subset are all the first rows. Every two of the first rows in the first subset have the first association relationship. The rows in the second subset are all the second rows. The first rows corresponding to the second rows in the second subset have the second association relationship with the first rows in the first subset. The second row set consists of rows that are of the second LDPC base matrix and that correspond to rows in a third subset and/or rows that are of the second LDPC base matrix and that correspond to rows in a fourth subset. The third subset consists of the second rows corresponding to the first rows in the first subset. The fourth subset consists of the first rows corresponding to the second rows in the second subset. Every two of the first rows in the fourth subset have the first association relationship.

For example, a row group includes a row C and a row D, a second row corresponding to the row C is a row A, a second row corresponding to the row D is a row B, and the row C and the row D have the first association relationship. The row A and the row B may be grouped together, and the row C and the row D may be grouped together. In this case, the first subset includes the row C and the row D, the second subset is an empty set (in other words, the first row set does not include the second subset), the third subset includes the row A and the row B, and the fourth subset is an empty set (in other words, the second row set does not include the fourth subset). The receive-end device may perform row-parallel decoding on a part that is of the LDPC codeword sequence and that corresponds to rows in the second LDPC base matrix that correspond to the row A and the row B, and perform row-parallel decoding on a part that is of the LDPC codeword sequence and that corresponds to rows in the second LDPC base matrix that correspond to the row C and the row D.

For example, a row group includes a row C and a row D, a second row corresponding to the row C is a row A, a second row corresponding to the row D is a row B, and the row C and the row D have the second association relationship. The row A and the row C may be grouped together, and the row B and the row D may be grouped together. In this case, the first subset includes the row C, the second subset includes the row A, the third subset includes the row D, and the fourth subset includes the row B. The receive-end device may perform row-parallel decoding on a part that is of the LDPC codeword sequence and that corresponds to rows in the second LDPC base matrix that correspond to the row A and the row C, and perform row-parallel decoding on a part that is of the LDPC codeword sequence and that corresponds to rows in the second LDPC base matrix that correspond to the row B and the row D.

For example, a row group includes a row D, a row E, and a row F, a second row corresponding to the row D is a row A, a row corresponding to the row E is a row B, a row corresponding to the row F is a row C, the row D and the row F have the first association relationship, the row D and the row E have the second association relationship, and the row E and the row F have the second association relationship. The row D, the row F, and the row B may be grouped together, and the row A, the row C, and the row E may be grouped together. In this case, the first subset includes the row D and the row F, the second subset includes the row B, the third subset includes the row A and the row C, and the fourth subset includes the row E. The receive-end device may perform row-parallel decoding on a part that is of the LDPC codeword sequence and that corresponds to rows in the second LDPC base matrix that correspond to the row D, the row F, and the row B, and perform row-parallel decoding on a part that is of the LDPC codeword sequence and that corresponds to rows in the second LDPC base matrix that correspond to the row A, the row C, and the row E.

It should be noted that the groups in the foregoing row-parallel decoding may be stored in the receive-end device, or may be predefined. This is not limited.

The following describes the technical solutions in embodiments of this application in detail with reference to several specific examples.

### Example 1

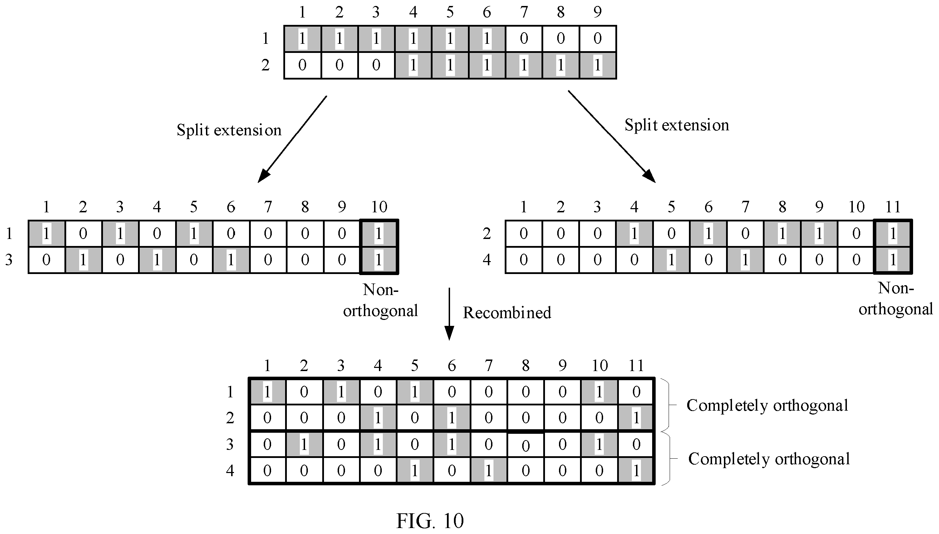

FIG. 10 shows an example of a technical solution according to an embodiment of this application. In this example, *k* = 2.

As shown in FIG. 10, a child node of a node 1 is a node 3, and a child node of a node 2 is a node 4.

If there is no correlation between the node 3 and the node 4, the node 1 and the node 3 can only be grouped together, and the node 2 and the node 4 can only be grouped together. The two groups each are quasi-orthogonal, that is, there are still overlapping elements in an extended node part.

If the first association relationship is introduced between the node 3 and the node 4, that is, the node 3 includes one extended node, edges or non-zero elements other than the extended node that are included in the node 3 are a proper subset of the node 1, the node 4 includes one extended node, edges or non-zero elements other than the extended node that are included in the node 4 are a proper subset of the node 2, the node 3 and the node 4 are orthogonal to each other, and a union set of non-zero elements of the node 3 and the node 4 includes an intersection set of non-zero elements of the node 1 and the node 2, a new grouping manner may be generated, such as grouping the node 1 and the node 2 together and grouping the node 3 and the node 4 together, so that the two groups obtained each are completely orthogonal. For details of the first association relationship, refer to FIG. 8A to FIG. 8D.

In this example, a plurality of parent nodes (such as the node 1 and the node 2) are grouped together, and a plurality of child nodes (such as the node 3 and the node 4) are grouped together. Child nodes of parent nodes in a same group have the first association relationship. The transmit-end device may perform row-parallel decoding on the plurality of parent nodes (such as the node 1 and the node 2), and perform row-parallel decoding on the plurality of child nodes (such as the node 3 and the node 4).

### Example 2

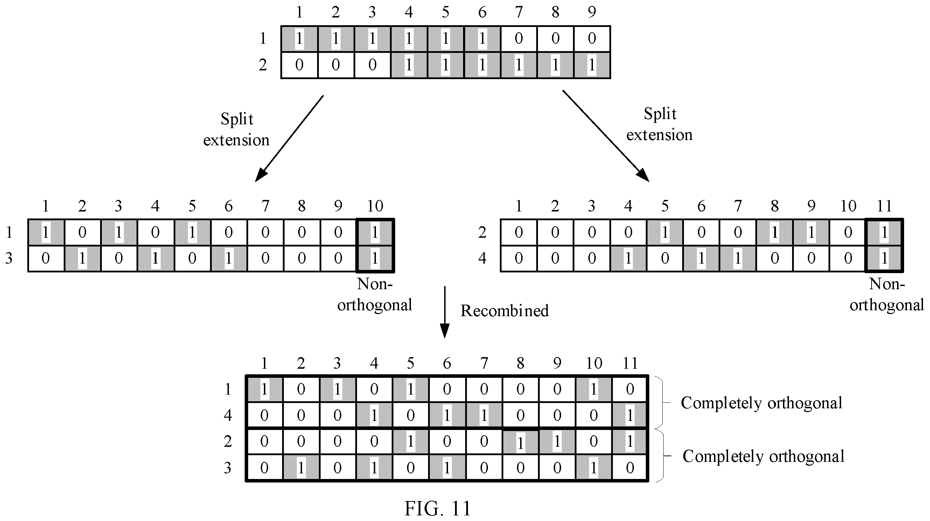

FIG. 11 shows another example of a technical solution according to an embodiment of this application. In this example, *k* = 2.

As shown in FIG. 11, a child node of a node 1 is a node 3, and a child node of a node 2 is a node 4.

If there is no correlation between the node 3 and the node 4, the node 1 and the node 3 can only be grouped together, and the node 2 and the node 4 can only be grouped together. The two groups each are quasi-orthogonal, that is, there are still overlapping elements in an extended node part.

If the second association relationship is introduced between the node 3 and the node 4, that is, the node 3 includes one extended node, edges or non-zero elements other than the extended node that are included in the node 3 are a proper subset of the node 1, the node 4 includes one extended node, edges or non-zero elements other than the extended node that are included in the node 4 are a proper subset of the node 2, and connection edges of the node 3 and the node 4 at an intersection position of the node 1 and the node 2 are completely the same, a new grouping manner may be generated, such as grouping the node 1 and the node 4 together and grouping the node 2 and the node 3 together, so that the two groups obtained each are completely orthogonal. For details of the second association relationship, refer to FIG. 9A to FIG. 9D.

In this example, the node 1 and the node 4 are grouped together, and the node 2 and the node 3 are grouped together. Child nodes of parent nodes in a same group have the first association relationship. The transmit-end device may perform row-parallel decoding on the node 1 and the node 4, and perform row-parallel decoding on the node 2 and the node 3.

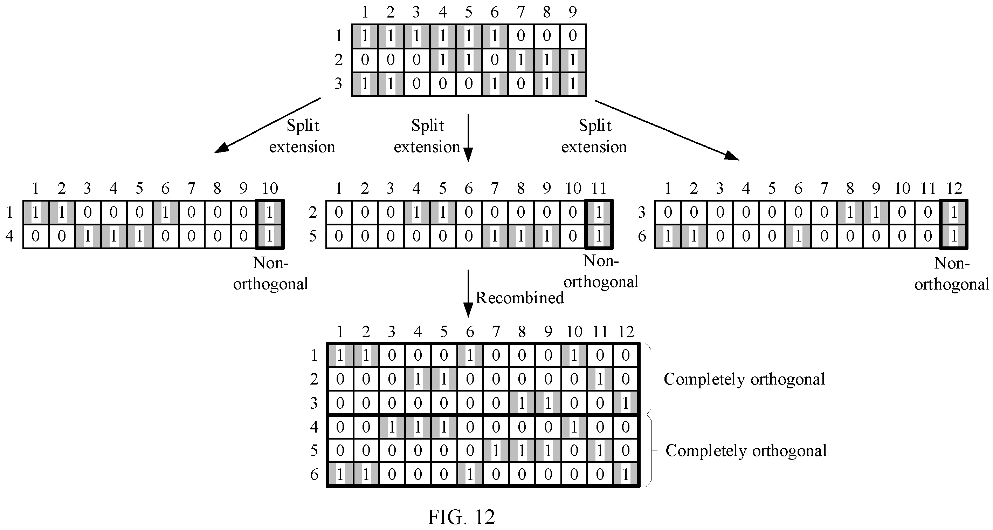

FIG. 12 shows another example of a technical solution according to an embodiment of this application. In this example, *k* = 3.

As shown in FIG. 12, a child node of a node 1 is a node 4, a child node of a node 2 is a node 5, and a child node of a node 3 is a node 6.

If there is no correlation between the nodes 4, 5, and 6, the node 1 and the node 4 can only be grouped together, the node 2 and the node 5 can only be grouped together, and the node 3 and the node 6 can only be grouped together. The three groups each are quasi-orthogonal, that is, there are still overlapping elements in an extended node part.

If the first association relationship is introduced between the nodes 4, 5, and 6, that is, the node 4 includes one extended node, edges or non-zero elements other than the extended node that are included in the node 4 are a proper subset of the node 1, the node 5 includes one extended node, edges or non-zero elements other than the extended node that are included in the node 5 are a proper subset of the node 2, the node 6 includes one extended node, edges or non-zero elements other than the extended node that are included in the node 6 are a proper subset of the node 3, the node 4 and the node 5 are orthogonal to each other, a union set of non-zero elements of the node 4 and the node 5 includes an intersection set of non-zero elements of the node 1 and the node 2, the node 4 and the node 6 are orthogonal to each other, a union set of non-zero elements of the node 4 and the node 6 includes an intersection set of non-zero elements of the node 1 and the node 3, the node 5 and the node 6 are orthogonal to each other, a union set of non-zero elements of the node 5 and the node 6 includes an intersection set of non-zero elements of the node 2 and the node 3, and a column weight of each column in a matrix region formed by the node 1, the node 2, and the node 3 is at most 2, a new grouping manner may be generated, such as grouping the node 1, the node 2, and the node 3 together and grouping the node 4, the node 5, and the node 6 together, so that the two groups obtained each are completely orthogonal. For details of the first association relationship, refer to FIG. 8A to FIG. 8D.

In this example, a plurality of parent nodes (such as the node 1, the node 2, and the node 3) are grouped together, and a plurality of child nodes (such as the node 4, the node 5, and the node 6) are grouped together. Child nodes of parent nodes in a same group have the first association relationship. The transmit-end device may perform row-parallel decoding on the plurality of parent nodes (such as the node 1, the node 2, and the node 3), and perform row-parallel decoding on the plurality of child nodes (such as the node 4, the node 5, and the node 6).

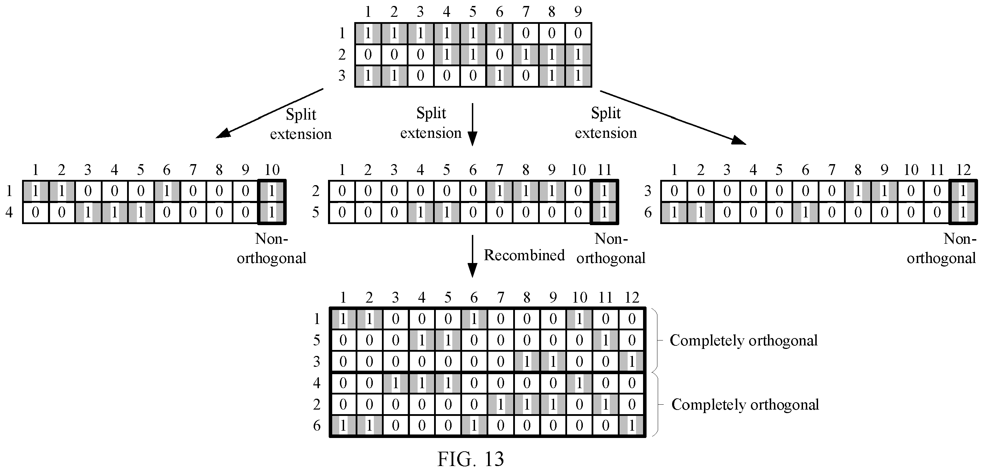

FIG. 13 shows another example of a technical solution according to an embodiment of this application. In this example, *k* = 3.

As shown in FIG. 13, a child node of a node 1 is a node 4, a child node of a node 2 is a node 5, and a child node of a node 3 is a node 6.

If there is no correlation between the nodes 4, 5, and 6, the node 1 and the node 4 can only be grouped together, the node 2 and the node 5 can only be grouped together, and the node 3 and the node 6 can only be grouped together. The three groups each are quasi-orthogonal, that is, there are still overlapping elements in an extended node part.

If the first association relationship and the second association relationship are introduced between the nodes 4, 5, and 6, for example, the node 4 includes one extended node, edges or non-zero elements other than the extended node that are included in the node 4 are a proper subset of the node 1, the node 5 includes one extended node, edges or non-zero elements other than the extended node that are included in the node 5 are a proper subset of the node 2, the node 6 includes one extended node, edges or non-zero elements other than the extended node that are included in the node 6 are a proper subset of the node 3, the node 4 and the node 6 are orthogonal to each other, a union set of non-zero elements of the node 4 and the node 6 includes an intersection set of non-zero elements of the node 1 and the node 3, connection edges of the node 4 and the node 5 at an intersection position of the node 1 and the node 2 are completely the same, connection edges of the node 5 and the node 6 at an intersection position of the node 2 and the node 3 are completely the same, and a column weight of each column in a matrix region formed by the node 1, the node 2, and the node 3 is at most 2, a new grouping manner may be generated, such as grouping the node 1, the node 3, and the node 5 together and grouping the node 2, the node 4, and the node 6 together, so that the two groups obtained each are completely orthogonal. For details of the first association relationship, refer to FIG. 8A to FIG. 8D. For details of the second association relationship, refer to FIG. 9A to FIG. 9D.

In this example, the node 1, the node 3, and the node 5 are grouped together, and the node 2, the node 4, and the node 6 are grouped together. The transmit-end device may perform row-parallel decoding on the node 1, the node 3, and the node 5, and perform row-parallel decoding on the node 2, the node 4, and the node 6.

The following describes performance of an LDPC code in embodiments of this application with reference to simulation results.

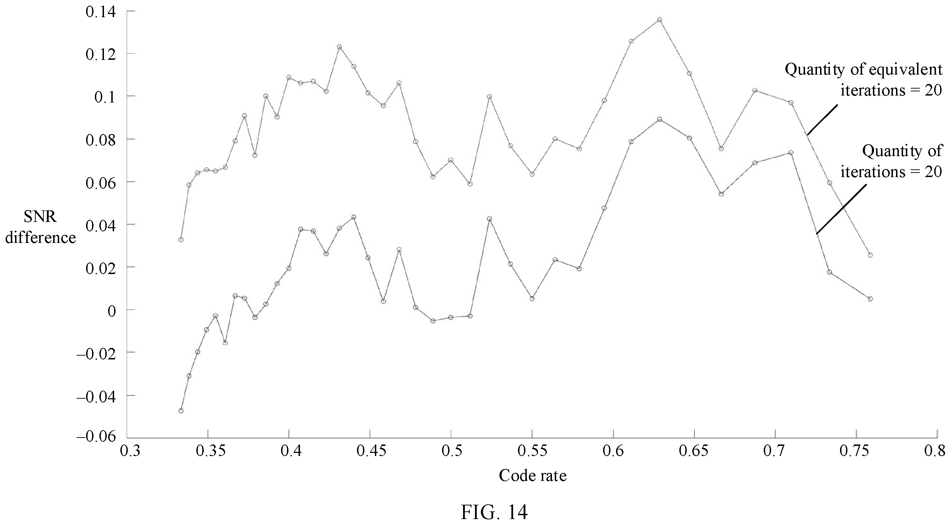

FIG. 14 shows a first simulation result of an SNR difference between an NR LDPC code and an LDPC code in this application at different code rates.

FIG. 14 shows a simulation result of an SNR difference between the NR LDPC code and the LDPC code in this application for a block error ratio (block error ratio, BLER)@1e-2. A vertical coordinate is the SNR difference between the NR LDPC code and the LDPC code in this application for BLER@1e-2, and a horizontal coordinate is the code rate. If the SNR difference is greater than 0, it indicates that the LDPC code in this application has good performance. If the SNR difference is less than 0, it indicates that the NR LDPC code has good performance. As shown in FIG. 14, compared with BG1 of the NR LDPC code, the LDPC code in this application has a gain in all code rate ranges of 0.4 and above. In addition, the LDPC code in this application has better row orthogonality than BG1 of the NR LDPC code.

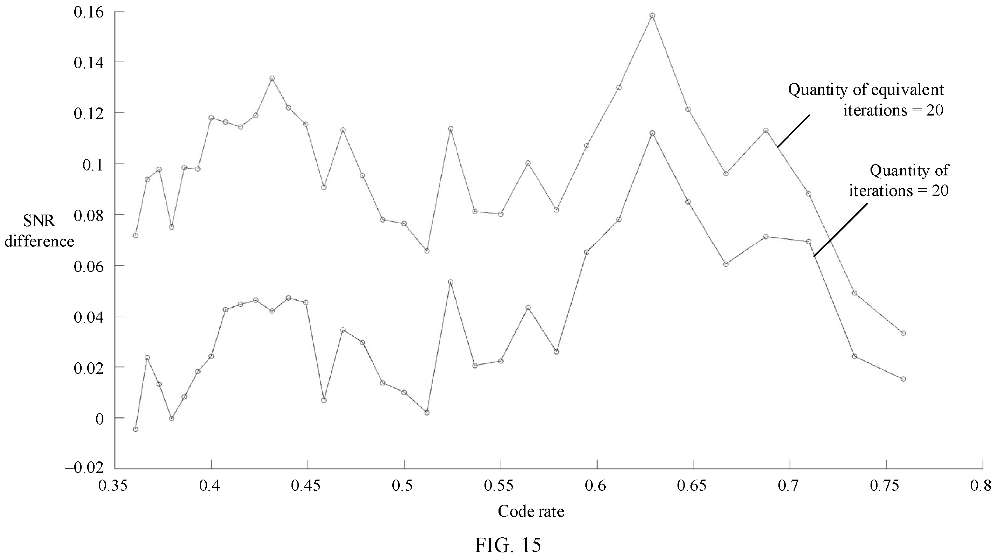

FIG. 15 shows a second simulation result of an SNR difference between an NR LDPC code and an LDPC code in this application at different code rates.

FIG. 15 shows a simulation result of an SNR difference between the NR LDPC code and the LDPC code in this application for BLER@1e-3. A vertical coordinate is the SNR difference between the NR LDPC code and the LDPC code in this application for BLER@1e-2, and a horizontal coordinate is the code rate. If the SNR difference is greater than 0, it indicates that the LDPC code in this application has good performance. If the SNR difference is less than 0, it indicates that the NR LDPC code has good performance. As shown in FIG. 15, compared with BG1 of the NR LDPC code, the LDPC code in this application has a gain in almost all code rate ranges. In addition, the LDPC code in this application has a slope gain of BLER-SNR, and a gain for BLER@1e-3 is greater than that for BLER@1e-2.

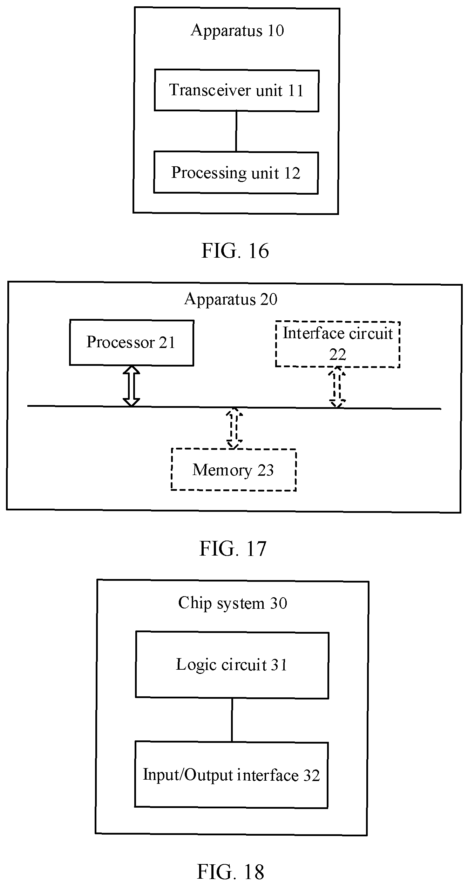

The foregoing describes the method embodiments provided in this application in detail with reference to FIG. 7 to FIG. 15. The following describes apparatus embodiments of this application with reference to FIG. 16 to FIG. 18.

It may be understood that to implement functions in the foregoing embodiments, apparatuses in FIG. 16 to FIG. 18 include corresponding hardware structures and/or software modules for performing each function. A person skilled in the art should be easily aware that in this application, the units and method steps in the examples described with reference to embodiments disclosed in this application can be implemented by hardware or a combination of hardware and computer software.

FIG. 16 and FIG. 17 are diagrams of structures of possible apparatuses according to embodiments of this application. These apparatuses may be configured to implement functions of the transmit-end device or the receive-end device in the foregoing method embodiments. Therefore, beneficial effects of the foregoing method embodiments can also be implemented.

As shown in FIG. 16, an apparatus 10 includes a transceiver unit 11 and a processing unit 12.

When the apparatus 10 is configured to implement the functions of the transmit-end device in the foregoing method embodiments, the transceiver unit 11 is configured to perform transceiving steps of the transmit-end device, such as step 703, and the processing unit 12 is configured to perform processing steps of the transmit-end device, such as steps 701 and 702. When the apparatus 10 is configured to implement the functions of the receive-end device in the foregoing method embodiments, the transceiver unit 11 is configured to perform transceiving steps of the receive-end device, such as step 703, and the processing unit 12 is configured to perform processing steps of the receive-end device, such as step 704.

For more detailed descriptions of the transceiver unit 11 and the processing unit 12, refer to related descriptions in the foregoing method embodiments. Details are not described herein again.

As shown in FIG. 17, an apparatus 20 includes a processing circuit 21. The processing circuit 21 is coupled to a memory 23. The memory 23 is configured to store instructions. When the apparatus 20 is configured to implement the foregoing method, the processing circuit 21 is configured to execute the instructions in the memory 23, to implement a function of the foregoing processing unit 12.

Optionally, the apparatus 20 further includes the memory 23.

Optionally, the apparatus 20 further includes a transceiver circuit 22. The transceiver circuit may be referred to as a communication interface. The processing circuit 21 and the transceiver circuit 22 are coupled to each other. It may be understood that the transceiver circuit 22 may be a transceiver or an input/output interface. When the apparatus 20 is configured to implement the foregoing method, the processing circuit 21 is configured to execute the instructions to implement the function of the foregoing processing unit 12, and the transceiver circuit 22 is configured to implement a function of the foregoing transceiver unit 11.

Optionally, the apparatus 20 may be the transmit-end device or the receive-end device. Correspondingly, the transceiver circuit may be a transceiver.

Optionally, the apparatus 20 may be a chip used in the transmit-end device or the receive-end device. Correspondingly, the transceiver circuit may be an input/output interface.

For example, when the apparatus 20 is a chip used in the transmit-end device or the receive-end device, the chip implements the functions of the transmit-end device or the receive-end device in the foregoing method embodiments. The chip receives information from another module (for example, a radio frequency module or an antenna) in the transmit-end device or the receive-end device, where the information is sent by another apparatus to the transmit-end device or the receive-end device; or the chip sends information to another module (for example, a radio frequency module or an antenna) in the transmit-end device or the receive-end device, where the information is sent by the transmit-end device or the receive-end device to another apparatus.

FIG. 18 is a diagram of a chip system 30 according to an embodiment of this application. The chip system 30 (which may alternatively be referred to as a processing system) includes a logic circuit 31 and an input/output interface (input/output interface) 32.

The logic circuit 31 may be a processing circuit in the chip system 30. The logic circuit 31 may be coupled and connected to a storage unit, and invoke instructions in the storage unit, to enable the chip system 30 to implement the methods and functions in embodiments of this application. The input/output interface 32 may be an input/output circuit in the chip system 30, and outputs information processed by the chip system 30, or inputs to-be-processed data or signaling information to the chip system 30 for processing.

In a solution, the chip system 30 is configured to implement the operations performed by the transmit-end device or the receive-end device in the foregoing method embodiments.

For example, the logic circuit 31 is configured to implement processing-related operations performed by the transmit-end device or the receive-end device in the foregoing method embodiments; and the input/output interface 32 is configured to implement sending-related and/or receiving-related operations performed by the transmit-end device or the receive-end device in the foregoing method embodiments.

This application further provides a communication apparatus, including a processing circuit. The processing circuit is coupled to a memory. The memory is configured to store a computer program or instructions and/or data. The processing circuit is configured to: execute the computer program or the instructions stored in the memory, or read the data stored in the memory, to perform the method in the foregoing method embodiments. Optionally, there are one or more processing circuits. Optionally, the communication apparatus includes the memory. Optionally, there are one or more memories. Optionally, the memory and the processing circuit are integrated together or disposed separately.

This application further provides a chip, including a processing circuit. The processing circuit is coupled to a memory. The memory is configured to store a computer program or instructions. The processing circuit is configured to execute the computer program or the instructions stored in the memory, to implement the method performed by the transmit-end device or the receive-end device in the foregoing method embodiments. The memory may be located inside the chip, or may be independent of the chip and located outside the chip. This is not limited herein.

This application further provides a computer-readable storage medium. The computer-readable storage medium stores computer instructions for implementing the method performed by the transmit-end device or the receive-end device in the foregoing method embodiments.

This application further provides a computer program product, including instructions. When the instructions are executed by a computer, the method performed by the transmit-end device or the receive-end device in the foregoing method embodiments is implemented.

This application further provides a communication system. The communication system includes at least one of the transmit-end device or the receive-end device in the foregoing embodiments.

For explanations and beneficial effects of related content in any one of the apparatuses provided above, refer to the corresponding method embodiments provided above. Details are not described herein again.

It may be understood that the processing circuit in embodiments of this application may be a processor or a circuit configured to perform a processing operation in the processor. The processor may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor, any regular processor, or the like.

The method steps in embodiments of this application may be implemented in a hardware manner, or may be implemented in a manner of executing software instructions by the processor. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk, a removable hard disk, a compact disc read-only memory (compact disc read-only memory, CD-ROM), or any other form of storage medium well-known in the art. For example, a storage medium is coupled to a processor, so that the processor can read information from the storage medium and write information into the storage medium. Certainly, the storage medium may alternatively be a component of the processor. The processor and the storage medium may be located in an ASIC. In addition, the ASIC may be located in a transmit-end device or a receive-end device. Certainly, the processor and the storage medium may alternatively exist in a transmit-end device or a receive-end device as discrete components.

All or some of the foregoing embodiments may be implemented by using software, hardware, firmware, or any combination thereof. When software is used to implement the embodiments, all or some of the embodiments may be implemented in a form of a computer program product. The computer program product includes one or more computer programs or instructions. When the computer programs or instructions are loaded and executed on a computer, the procedures or functions in embodiments of this application are all or partially executed. The computer may be a general-purpose computer, a special-purpose computer, a computer network, a network device, user equipment, or another programmable apparatus. The computer programs or instructions may be stored in a computer-readable storage medium, or may be transmitted from a computer-readable storage medium to another computer-readable storage medium. For example, the computer programs or instructions may be transmitted from a website, computer, server, or data center to another website, computer, server, or data center in a wired or wireless manner. The computer-readable storage medium may be any usable medium that can be accessed by the computer, or a data storage device, for example, a server or a data center, integrating one or more usable media. The usable medium may be a magnetic medium, for example, a floppy disk, a hard disk, or a magnetic tape; or may be an optical medium, for example, a digital video disc; or may be a semiconductor medium, for example, a solid-state drive.

In various embodiments of this application, unless otherwise stated or there is a logic conflict, terms and/or descriptions in different embodiments are consistent and may be mutually referenced, and technical features in different embodiments may be combined into a new embodiment based on an internal logical relationship thereof.

Unless otherwise stated, meanings of all technical and scientific terms used in embodiments of this application are the same as those usually understood by a person skilled in the technical field of this application. The terms used in this application are merely intended to describe objectives of specific embodiments, and are not intended to limit the scope of this application. It should be understood that the foregoing is an example for description, and the foregoing examples are merely intended to help a person skilled in the art understand embodiments of this application, but are not intended to limit embodiments of this application to examples of specific values or specific scenarios. It is clear that a person skilled in the art can make various equivalent modifications or variations based on the examples described above, and such modifications and variations also fall within the scope of embodiments of this application.

## Claims

1. A low-density parity-check LDPC code-based communication method, wherein the method comprises:
obtaining an information bit sequence;
performing LDPC encoding on the information bit sequence based on a first LDPC base matrix and indication information to obtain an LDPC codeword sequence, wherein the indication information comprises first information, the first information indicates a plurality of row pairs, each row pair in the plurality of row pairs comprises a first row and a second row, a set of column numbers of columns in which non-zero elements in first x elements of the first row in the row pair are located is a proper subset of a set of column numbers of columns in which non-zero elements in first x elements of the second row in the row pair are located, and x is a positive integer; and the plurality of first rows indicated by the first information form one or more row groups, each row group in the one or more row groups comprises at least two of the first rows, a column weight of each column in a matrix region formed by the second rows corresponding to the at least two first rows is less than or equal to 2, and the at least two first rows have an association relationship; and
sending the LDPC codeword sequence.

2. The method according to claim 1, wherein performing LDPC encoding on the information bit sequence based on the first LDPC base matrix and the indication information to obtain the LDPC codeword sequence comprises:
obtaining a second LDPC base matrix based on the first LDPC base matrix and the indication information; and
performing LDPC encoding on the information bit sequence based on the second LDPC base matrix to obtain the LDPC codeword sequence, wherein a row that is of the second LDPC base matrix and that corresponds to the first row is obtained by performing elimination on the second row in the same row pair as the first row.

3. The method according to claim 1 or 2, wherein
the association relationship comprises a first association relationship and/or a second association relationship;
the two first rows having the first association relationship are orthogonal to each other, and a union set of column numbers of columns in which non-zero elements of the two first rows are located comprises an intersection set of column numbers of columns in which non-zero elements of the two second rows corresponding to the two first rows are located; and
the two first rows having the second association relationship have a same connection edge at a first position, and a column number of the first position belongs to an intersection set of column numbers of columns in which non-zero elements of the two second rows corresponding to the two first rows are located.

4. A low-density parity-check LDPC code-based communication method, wherein the method comprises:
receiving an LDPC codeword sequence; and
decoding the LDPC codeword sequence based on a first LDPC base matrix and indication information, wherein the indication information comprises first information, the first information indicates a plurality of row pairs, each row pair in the plurality of row pairs comprises a first row and a second row, a set of column numbers of columns in which non-zero elements in first x elements of the first row in the row pair are located is a proper subset of a set of column numbers of columns in which non-zero elements in first x elements of the second row in the row pair are located, and x is a positive integer; and the plurality of first rows indicated by the first information form one or more row groups, each row group in the one or more row groups comprises at least two of the first rows, a column weight of each column in a matrix region of the second rows corresponding to the at least two first rows is less than or equal to 2, and the at least two first rows have an association relationship.

5. The method according to claim 4, wherein decoding the LDPC codeword sequence based on the first LDPC base matrix and the indication information comprises:
obtaining a second LDPC base matrix based on the first LDPC base matrix and the indication information; and
decoding the LDPC codeword sequence based on the second LDPC base matrix, wherein a row that is of the second LDPC base matrix and that corresponds to the first row is obtained by performing elimination on the second row in the same row pair as the first row.

6. The method according to claim 4 or 5, wherein
the association relationship comprises a first association relationship and/or a second association relationship;
the two first rows having the first association relationship are orthogonal to each other, and a union set of column numbers of columns in which non-zero elements of the two first rows are located comprises an intersection set of column numbers of columns in which non-zero elements of the two second rows corresponding to the two first rows are located; and
the two first rows having the second association relationship have a same connection edge at a first position, and a column number of the first position belongs to an intersection set of column numbers of columns in which non-zero elements of the two second rows corresponding to the two first rows are located.

7. The method according to claim 6, wherein decoding the LDPC codeword sequence based on the second LDPC base matrix comprises:
performing row-parallel decoding on a part that is of the LDPC codeword sequence and that corresponds to rows in a first row set, and performing row-parallel decoding on a part that is of the LDPC codeword sequence and that corresponds to rows in a second row set; wherein
a union set of the first row set and the second row set comprises rows that are of the second LDPC base matrix and that correspond to the at least two first rows and rows that are of the second LDPC base matrix and that correspond to the second rows corresponding to the at least two first rows;
the first row set consists of rows that are of the second LDPC base matrix and that correspond to rows in a first subset and/or rows that are of the second LDPC base matrix and that correspond to rows in a second subset, the rows in the first subset are all the first rows, every two of the first rows in the first subset have the first association relationship, the rows in the second subset are all the second rows, and the first rows corresponding to the second rows in the second subset have the second association relationship with the first rows in the first subset; and
the second row set consists of rows that are of the second LDPC base matrix and that correspond to rows in a third subset and/or rows that are of the second LDPC base matrix and that correspond to rows in a fourth subset, the third subset consists of the second rows corresponding to the first rows in the first subset, the fourth subset consists of the first rows corresponding to the second rows in the second subset, and every two of the first rows in the fourth subset have the first association relationship.

8. The method according to claim 3, 6, or 7, wherein
in pairwise combinations of the at least two first rows, a quantity of combinations having the first association relationship and a quantity of combinations having the second association relationship are related to a quantity of the first rows comprised in the at least two first rows.

9. The method according to claim 8, wherein
in the pairwise combinations of the at least two first rows, $\left(\begin{matrix}k - i \\ 2\end{matrix}\right) + \left(\begin{matrix}i \\ 2\end{matrix}\right)$ combinations have the first association relationship, and $\left(\begin{matrix}k \\ 2\end{matrix}\right) - \left(\begin{matrix}k - i \\ 2\end{matrix}\right) - \left(\begin{matrix}i \\ 2\end{matrix}\right)$ combinations have the second association relationship, wherein k is the quantity of the first rows comprised in the at least two first rows, $0 \leq i \leq \left⌊\frac{k}{2}\right⌋ , \left(\begin{matrix}k - i \\ 2\end{matrix}\right)$ represents a quantity of combinations of any two rows selected from *k - i* rows, $\left(\begin{matrix}k \\ 2\end{matrix}\right)$ represents a quantity of combinations of any two rows selected from *k* rows, $\left(\begin{matrix}i \\ 2\end{matrix}\right)$ represents a quantity of combinations of any two rows selected from *i* rows, and └ ┘ represents rounding down.

10. The method according to any one of claims 1 to 9, wherein
each row pair in the plurality of row pairs corresponds to two rows in the first LDPC base matrix;
the indication information is in a form of a sequence, and the first information is a sequence of a row number of the second row in each of the one or more row pairs; and
in one of the row pairs, a position of the row number of the second row in the sequence corresponding to the indication information is a row number of the first row, and the position of the row number of the second row in the sequence corresponding to the indication information is greater than the row number of the first row.

11. The method according to claim 10, wherein
the sequence corresponding to the first information comprises one or more segments, and row numbers in a *t^{th}* segment of the one or more segments are a permutation form of {1, 2,..., 2^{*t*-1} M - 1, 2^{*t*-1}M}, wherein *t* and M are positive integers.

12. The method according to claim 10, wherein
the indication information further comprises second information, and the second information indicates one or more third rows.

13. The method according to claim 12, wherein
the second information comprises one or more first characters, and positions of the one or more first characters in the sequence corresponding to the indication information correspond to row numbers of the one or more third rows.

14. The method according to claim 12 or 13, wherein
the indication information further comprises third information, and the third information indicates one or more fourth rows.

15. The method according to claim 14, wherein
the third information comprises M second characters or M row numbers, and the M row numbers are sequentially 1, 2, ..., M - 1, and M, wherein M is a positive integer.

16. The method according to claim 15, wherein
the first character and/or the second character are/is a value other than a row number of the first LDPC base matrix.

17. The method according to claim 15 or 16, wherein
the sequence corresponding to the indication information sequentially comprises a first segment, a second segment, a third segment, a fourth segment, and a fifth segment, wherein the first segment consists of the third information, the second segment consists of a first part of the second information, the third segment consists of a first part of the first information, the fourth segment consists of a second part of the first information and a second part of the second information, and the fifth segment consists of a third part of the second information.

18. The method according to claim 17, wherein
the third segment comprises one or more sub-segments, and row numbers in an *r^{th}* segment of the one or more sub-segments are a permutation form of {1, 2, ..., 2^{*r*-1}(M + T) - 1, 2^{*r*-1}(M + T)}, wherein *r* is a positive integer, and T is a quantity of characters in the first part of the second information.

19. A communication apparatus, comprising a module or unit configured to perform the method according to any one of claims 1 to 18.

20. A communication apparatus, comprising a processor and an interface circuit, wherein the interface circuit is configured to: receive a signal from a communication apparatus other than the communication apparatus and transmit the signal to the processor, or send a signal from the processor to the communication apparatus other than the communication apparatus; and the processor is configured to implement the method according to any one of claims 1 to 18 by using a logic circuit or executing code instructions.

21. The communication apparatus according to claim 20, wherein the communication apparatus is a chip or a chip system.

22. A computer-readable storage medium, wherein the storage medium stores a computer program or instructions, and when the computer program or the instructions are executed by a communication apparatus, the method according to any one of claims 1 to 18 is implemented.

23. A computer program product, comprising a computer program, wherein when the computer program is run, the method according to any one of claims 1 to 18 is implemented.

24. A communication system, comprising:
a transmit-end device configured to perform the method according to any one of claims 1 to 3 and 8 to 18; and
a receive-end device configured to perform the method according to any one of claims 4 to 18.
